(19) Europäisches Patentamt
European Patent Office
Office européen des brevets

(11)  **EP 4 043 534 B1**

(12)  **EUROPEAN PATENT SPECIFICATION**

(45) Date of publication and mention
of the grant of the patent:
**29.11.2023  Bulletin 2023/48**

(21) Application number: **21218196.0**

(22) Date of filing: **29.12.2021**

(51) International Patent Classification (IPC):
**C09K 11/70** (2006.01)    **H05B 33/14** (2006.01)
**C09K 11/88** (2006.01)    **H10K 50/115** (2023.01)

(52) Cooperative Patent Classification (CPC):
**C09K 11/70; C09K 11/883; H05B 33/14;
H10K 50/115**

(54)  **LUMINESCENT FILM AND DEVICE INCLUDING THE SAME**

LUMINESZENTE FOLIE UND VORRICHTUNG DAMIT

FILM LUMINESCENT ET DISPOSITIF LE COMPRENANT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **28.12.2020  KR 20200185150
27.12.2021  KR 20210189032**

(43) Date of publication of application:
**17.08.2022  Bulletin 2022/33**

(73) Proprietor: **Samsung Electronics Co., Ltd.
Gyeonggi-do 16677 (KR)**

(72) Inventors:
• **HAN, Yong Seok**
**Anyang-si (KR)**
• **JANG, Eun Joo**
**Suwon-si (KR)**
• **JANG, Hyo Sook**
**Suwon-si (KR)**
• **CHO, Oul**
**Hwaseong-si (KR)**
• **MIN, Jihyun**
**Dongjak-gu (KR)**
• **WON, Yuho**
**Seocho-gu (KR)**

(74) Representative: **Elkington and Fife LLP
Prospect House
8 Pembroke Road
Sevenoaks, Kent TN13 1XR (GB)**

(56) References cited:
**US-A1- 2018 151 817    US-A1- 2019 367 804
US-A1- 2020 083 470**

**Description**

FIELD OF THE INVENTION

A light emitting film including a light emitting nanostructure (e.g., a quantum dot) and a device including the same are disclosed.

BACKGROUND OF THE INVENTION

Nanoparticles may exhibit different properties than a bulk material in terms of physical characteristics (e.g., bandgap energies, melting points, etc.) that are known to be intrinsic in the bulk material. For example, luminescent nanostructure(s) may be provided with photo-energy or electrical energy and may emit light. The luminescent nanostructures may have use(s) in various devices including an electronic device.

A light emitting device comprising a light emitting layer disposed between a first and a second electrode and comprising core/shell quantum dots is disclosed in US2018151817 A1.

SUMMARY OF THE INVENTION

The invention provides an environmentally friendly light emitting nanostructures (e.g., quantum dots) showing, e.g., exhibiting, desired properties and for example, not including toxic heavy metals.

A method of producing the light-emitting nanostructure is disclosed.

An aspect provides a light-emitting film that includes the light emitting nanostructures.

An embodiment provides a device (e.g., an electroluminescent device) including the light emitting nanostructures.

An embodiment provides a display apparatus including the light emitting nanostructures.

A light-emitting device according to the invention is provided in accordance with claim 1.

In a two dimensional image obtained by a transmission electron microscopy analysis, the light emitting nanostructures may show, e.g., exhibit, a cubicity defined by the following equation of greater than or equal to about 0.75:

$$B/A' = \text{cubicity}$$

wherein A' is a total area of the light emitting nanostructures in the two dimensional image, and B is an area of (100) planes of the light emitting nanostructures in the two dimensional image.

The zinc chalcogenide may include a first zinc chalcogenide including zinc and selenium, and a second zinc chalcogenide including zinc and sulfur.

The light emitting device may be configured to exhibit a maximum external quantum efficiency (EQE) of greater than or equal to about 9%, greater than or equal to about 9.5%, or greater than or equal to about 10%.

The light emitting device may be configured to exhibit a maximum EQE of greater than or equal to about 10.2%.

The light emitting device may be configured to exhibit a maximum EQE of greater than or equal to about 11%, greater than or equal to about 12%, greater than or equal to about 12.5%, greater than or equal to about 13%, or greater than or equal to about 14%.

The light emitting device may be configured to exhibit a maximum luminance of greater than or equal to about 200,000 candelas per square meter ($cd/m^2$), greater than or equal to about 250,000 $cd/m^2$, or greater than or equal to about 280,000 $cd/m^2$.

The light emitting device may be configured to exhibit a maximum luminance of greater than or equal to about 300,000 $cd/m^2$, greater than or equal to about 310,000 $cd/m^2$, greater than or equal to about 320,000 $cd/m^2$, greater than or equal to about 330,000 $cd/m^2$, greater than or equal to about 340,000 $cd/m^2$, or greater than or equal to about 350,000 $cd/m^2$.

The green light or the light emitting nanostructures may be configured to exhibit a maximum luminescent peak wavelength of greater than or equal to 490 nanometers (nm) and less than or equal to 580 nm.

The light emitting nanostructures may include quantum dots.

The light emitting nanostructures or the quantum dots (hereinafter, "light emitting nanostructures) do not include cadmium, lead, or a combination thereof.

The light emitting nanostructures may have a core shell structure including a core and a shell disposed on the core. The core may include the first semiconductor nanocrystal. The shell may include the second semiconductor nanocrystal (e.g., the zinc chalcogenide such as the first zinc chalcogenide, the second zinc chalcogenide, or a combination thereof).

The core or the first semiconductor nanocrystal may include an indium phosphide optionally further including zinc (e.g., an indium phosphide, an indium zinc phosphide, or a combination thereof). The second semiconductor nanocrystal or the shell may include a first zinc chalcogenide (for example, a zinc selenide) and a second zinc chalcogenide (for example, a zinc sulfide). In an aspect, the second semiconductor nanocrystal includes a zinc selenide sulfide.

The shell may be a multi layered shell. The multi layered shell may include a first shell layer including zinc, selenium, and optionally sulfur and a second shell layer disposed on the first shell layer, the second shell layer including zinc, sulfur, and optionally selenium, and a composition of the first shell layer may be different than a composition of the second shell layer. The first shell layer may be disposed directly on the core. The first shell layer may be located between the core and the second shell layer.

The first shell layer may include a zinc selenide, a zinc selenide sulfide, or a combination thereof. The first shell layer may or may not include sulfur. The second shell layer may include a zinc sulfide, a zinc selenide sulfide, or a combination thereof. The shell may have a composition varying in a radial direction.

The light emitting nanostructures or the quantum dots may include a mole ratio of zinc to indium of greater than or equal to 43:1, for example, greater than or equal to about 44:1, greater than or equal to about 45:1, greater than or equal to about 49:1, greater than or equal to about 50:1. The light emitting nanostructures or the quantum dots may include a mole ratio of zinc to indium of greater than about 50:1, greater than or equal to about 50.5:1, greater than or equal to about 51:1, or greater than or equal to about 52:1.

The light emitting nanostructures or the quantum dots may include a mole ratio of sulfur to indium that is greater than or equal to about 11:1, greater than or equal to 11.5:1, greater than or equal to about 12:1, greater than or equal to about 12.3:1, or greater than or equal to about 12.5:1.

The light emitting nanostructures or the quantum dots may include a mole ratio of selenium to indium that is greater than about 21:1, greater than or equal to 21.8:1, greater than or equal to about 22:1, or greater than or equal to about 29:1.

The light emitting nanostructures or the quantum dots may include a mole ratio of indium to a sum of selenium and sulfur that is less than or equal to about 0.04:1.

The light emitting nanostructures or the quantum dots may include a mole ratio of zinc to a sum of selenium and sulfur that is less than or equal to 1.5:1, less than or equal to about 1.2:1, less than or equal to about 1.17:1, or less than or equal to about 1:1.

The light emitting nanostructures or the quantum dots may include a mole ratio of sulfur to selenium of less than or equal to 0.5:1.

The average value of the squareness may be greater than or equal to about 0.83, greater than or equal to about 0.85, or greater than or equal to about 0.9.

The cubicity (or an average value thereof) may be greater than or equal to about 0.8, greater than or equal to 0.85, or greater than or equal to about 0.9.

An average particle size of the light emitting nanostructures may be greater than or equal to 7 nm, greater than or equal to about 7.5 nm, greater than or equal to about 8 nm, or greater than or equal to about 9 nm.

The light emitting nanostructures may exhibit a particle size distribution of less than or equal to 10%, less than or equal to about 9%, less than or equal to about 8%, or less than or equal to about 7% of an average particle size.

A thickness of the light emitting layer may be greater than or equal to 10 nm.

The light emitting layer may not have a discontinuity running, e.g., passing, through a thickness, e.g., an entirety of the thickness, of the light emitting layer.

The light emitting device may further include an electron auxiliary layer, a hole auxiliary layer, or a combination thereof between the first electrically conducting layer and the second electrically conducting layer.

The hole auxiliary layer may include an organic compound having a highest occupied molecular orbital (HOMO) energy level of greater than or equal to about 5.0 electronvolts (eV) and less than or equal to about 5.5 eV.

The electron auxiliary layer may include nanoparticles of a metal oxide including zinc and optionally a first metal.

The first metal may include Mg, Ca, Zr, W, Li, Ti, Y, Al, Co, or a combination thereof.

In another aspect of the invention, a light emitting film is provided in accordance with claim 7.

The light emitting nanostructures may include a mole ratio between the elements included therein that is set forth herein.

In an embodiment, the light emitting nanostructures may include a mole ratio indium with respect to a sum of selenium and sulfur that is less than or equal to 0.04:1.

In an embodiment, the light emitting nanostructures may include a mole ratio zinc with respect to a sum of selenium and sulfur that is less than or equal to 1.5:1, or greater than or equal to about 1:1

The cubicity of the light emitting nanostructures and the average value of the squareness of the light emitting nanostructures may be, each independently, greater than or equal to 0.83.

The cubicity of the light emitting nanostructures may be greater than or equal to about 0.83. The average value of the squareness of the light emitting nanostructures may be greater than or equal to about 0.83.

The light emitting nanostructures may include quantum dots.

The light emitting nanostructures or the quantum dots may have a core shell structure, for example, as set forth herein.

An average particle size of the light emitting nanostructures may be greater than or equal to 7 nm. A particle size distribution of the light emitting nanostructures may be less than or equal to 10% of the average size thereof.

The light emitting nanostructures may be configured to emit green light.

The light emitting nanostructures may be configured to exhibit an absolute quantum yield of greater than or equal to about 90%, a full width at half maximum of less than or equal to about 40 nm, or both.

A layered structure may include a hole auxiliary layer and an electron auxiliary layer for example, facing each other, and the aforementioned light emitting film disposed between the hole auxiliary layer and the electron auxiliary layer.

An electroluminescent device includes a first electrically conducting layer (e.g., a first electrode) and a second electrically conducting layer (e.g., a second electrode), and a light emitting layer including light emitting nanostructures and disposed between the first electrically conducting layer and the second electrically conducting layer, wherein the light emitting layer does not include cadmium, lead, or a combination thereof, the light emitting nanostructures includes a first semiconductor nanocrystal including a Group III-V compound and a second semiconductor nanocrystal including a zinc chalcogenide, wherein the Group III-V compound includes indium, phosphorus, and zinc, wherein the zinc chalcogenide include zinc, selenium, and sulfur, wherein a maximum EQE of the electroluminescent device is greater than or equal to about 10% and a maximum luminance of the electroluminescent device is greater than or equal to about 300,000 cd/m$^2$.

The electroluminescent device (or the light emitting layer or the light emitting nanostructures) may be configured to emit green light.

The aforementioned details about the light emitting device may be applied to, e.g., used in, the electroluminescent device of an embodiment.

The light-emitting device or the electroluminescent device may further include a charge auxiliary layer disposed between the first electrically conducting layer and the light emitting layer; between the second electrically conducting layer and the light emitting layer; or between the first electrically conducting layer and the light emitting layer and between the second electrically conducting layer and the light emitting layer. The charge auxiliary layer may include a hole auxiliary layer, an electron auxiliary layer, or a combination thereof.

A T90 of the electroluminescent device may be greater than or equal to about 100 hours.

A display device may include the light emitting device, the light emitting film, or the electroluminescent device.

An aspect of the invention provides the aforementioned light emitting nanostructures (e.g., quantum dots).

The light emitting nanostructures or a light emitting layer (or film) including the same may be environmentally friendly as the light emitting nanostructures or a light emitting layer (or film) including the same does not include a toxic heavy metal such as lead, cadmium, or mercury, and may exhibit improved properties (e.g., improved EQE, enhanced luminance, improved reliability, or a desired light emitting property). The light emitting nanostructures or a light emitting layer (or film) including the same of an embodiment may be used in various display devices and biological labeling (e.g., biosensors or bio-imaging), photodetectors, solar cells, hybrid composites, and the like. The light emitting device may contribute to realization of, e.g., providing, improved display quality when being applied to, e.g., used in, a display device.

A method of preparing light emitting nanostructures includes reacting a zinc precursor, a selenium precursor, and a sulfur precursor at a temperature of greater than about 320 °C in the presence of a nanoparticle including a first semiconductor nanocrystal including a Group III-V compound and an organic ligand in an organic solvent to form a second semiconductor nanocrystal including a zinc chalcogenide, wherein the Group III-V compound includes indium, phosphorus, and optionally zinc, wherein the zinc chalcogenide includes zinc, selenium, and sulfur,

wherein the selenium precursor is added or injected in a split manner, intermittently to a reaction medium at least two times, in a different aliquot each time, respectively, optionally together with a zinc precursor.

wherein the light emitting nanostructures exhibit a zinc blende structure, and wherein in a two dimensional image of the light emitting nanostructures obtained by an electron microscopy analysis, an average value of squareness of the light emitting nanostructures defined by the following equation is greater than or equal to about 0.8:

$$\text{Squareness} = A/C$$

wherein A is an area of a given light emitting nanostructure in the two dimensional image, and C is an area of a smallest square that covers the given light emitting nanostructure.

In the method, the sulfur precursor may be added or injected once or at least two times, for example, in a same or different aliquot(s) each time, respectively, to a reaction medium, optionally together with a zinc precursor.

BRIEF DESCRIPTION OF THE DRAWINGS

This patent or application file contains at least one drawing executed in color. Copies of this patent or patent application publication with color drawing(s) will be provided by the Office upon request and payment of the necessary fee.

The above and other advantages and features of this disclosure will become more apparent by describing in further detail exemplary embodiments thereof with reference to the accompanying drawings, in which:

FIG. 1 is a schematic view illustrating a concept of the cubicity.
FIG. 2 is a cross-sectional representation of a light-emitting device according to an embodiment.
FIG. 3 is a cross-sectional representation of a light-emitting device.
FIG. 4 is a schematic cross-sectional representation of a light-emitting device.
FIG. 5A shows a transmission electron microscopy image of the light emitting nanostructures synthesized in Example 5.
FIG. 5B shows a high resolution transmission electron microscopy image of a nanostructures synthesized in Example 5 showing an area of (100) plane thereof.
FIG. 5C shows a view showing a two dimensional transmission electron microscopy (TEM) image of a given light emitting nanostructure together with an area of a smallest square that covers the given light emitting nanostructure.

DETAILED DESCRIPTION OF THE EMBODIMENTS

Advantages and characteristics of this disclosure, and a method for achieving the same, will become evident referring to the following example embodiments together with the drawings attached hereto. However, the embodiments should not be construed as being limited to the embodiments set forth herein. Rather, these embodiments are provided so that this disclosure will be thorough and complete, and will fully convey the scope of the invention to those skilled in the art.

If not defined otherwise, all terms in the specification (including technical and scientific terms) are used as commonly understood by a person of ordinary skilled in the art. It will be further understood that terms, such as those terms defined in a common dictionary should be interpreted as having a meaning that is consistent with their meaning in the context of the relevant art, and may not be interpreted ideally or exaggeratedly unless clearly defined. The terminology used herein is for the purpose of describing particular embodiments and is not intended to be limiting.

As used herein, the singular forms "a," "an," and "the" are intended to include the plural forms, including "at least one," unless the content clearly indicates otherwise. "At least one" is not to be construed as limiting "a" or "an." "Or" means "and/or." As used herein, the term "and/or" includes any and all combinations of one or more of the associated listed items. It will be further understood that the terms "comprise" and variations such as "comprises," "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present. In order to clearly illustrate the embodiments in the drawings, some portions not really relevant to the explanation may be omitted.

It will be understood that, although the terms "first," "second," "third," etc., may be used herein to describe various elements, components, regions, layers and/or sections, these elements, components, regions, layers and/or sections should not be limited by these terms. These terms are only used to distinguish one element, component, region, layer or section from another element, component, region, layer, or section. Thus, "a first element," "component," "region," "layer," or "section" discussed below could be termed a second element, component, region, layer, or section without departing from the teachings herein.

"About" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm$ 10%, $\pm$ 5% of the stated value.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

As used herein, the expression "not including cadmium (or other harmful heavy metal)" may refer to the case in which a concentration of each of cadmium (or another heavy metal deemed harmful) may be less than or equal to about 100 parts per million by weight (ppmw), less than or equal to about 50 ppmw, less than or equal to about 10 ppmw, less than or equal to about 1 ppmw, less than or equal to about 0.1 ppmw, less than or equal to about 0.01 ppmw, or about zero. In an aspect of the invention, substantially no amount of cadmium (or other heavy metal) may be present or, if present, an amount of cadmium (or other heavy metal) may be less than or equal to a detection limit or as an impurity level of a given analysis tool (e.g., an inductively coupled plasma atomic emission spectroscopy).

Hereinafter, values of a work function, a conduction band, or a lowest unoccupied molecular orbital (LUMO) (or valence band or HOMO) energy level is expressed as an absolute value from a vacuum level. In addition, when the work function or the energy level is referred to be "deep," "high" or "large," the work function or the energy level has a large absolute value based on "0 eV" of the vacuum level, while when the work function or the energy level is referred to be "shallow," "low," or "small," the work function or energy level has a small absolute value based on "0 eV" of the vacuum level.

The HOMO energy level, LUMO energy level, or a work function recited herein may be a value measured by an appropriate method, which is not particularly limited. The HOMO energy level, LUMO energy level, or a work function recited herein may be measured by using a Cyclic Volumetry method, a spectroscopy method such as an ultraviolet-visible (UV-Vis) spectroscopy, Ultraviolet Photoelectron Spectroscopy (UPS), a Photoelectron spectroscopy in air (e.g., AC-3), a Kelvin Probe force microscopy, or a combination thereof.

As used herein, the term "Group" may refer to a group of Periodic Table.

As used herein, "Group III" refers to Group IIIA and Group IIIB, and examples of Group IIIA metal may be Al, In, Ga, and Tl, and examples of Group IIIB may be scandium, yttrium, or the like, but are not limited thereto.

As used herein, "Group V" includes Group VA and includes nitrogen, phosphorus, arsenic, antimony, and bismuth, but is not limited thereto.

As used herein, the average (value) may be mean or median. In an embodiment, the average (value) may be a mean average.

As used herein, when a definition is not otherwise provided, "substituted" refers to replacement of hydrogen of a compound, a group, or moiety by a substituent such as a C1 to C30 alkyl group, a C2 to C30 alkenyl group, a C2 to C30 alkynyl group, a C2 to C30 epoxy group, a C2 to C30 alkenyl group, a C2 to C30 alkylester group, a C3 to C30 alkenylester group (e.g., acrylate group, methacrylate group), a C6 to C30 aryl group, a C7 to C30 alkylaryl group, a C1 to C30 alkoxy group, a C1 to C30 heteroalkyl group, a C3 to C30 heteroalkylaryl group, a C3 to C30 cycloalkyl group, a C3 to C15 cycloalkenyl group, a C6 to C30 cycloalkynyl group, a C2 to C30 heterocycloalkyl group, a halogen (-F, -Cl, -Br, or -I), a hydroxy group (-OH), a nitro group ($-NO_2$), a cyano group (-CN), an amino group (-NRR', wherein R and R' are each independently hydrogen or a C1 to C6 alkyl group), an azido group ($-N_3$), an amidino group ($-C(=NH)NH_2$), a hydrazino group ($-NHNH_2$), a hydrazono group ($=N(NH_2)$), an aldehyde group (-C(=O)H), a carbamoyl group ($-C(O)NH_2$), a thiol group (-SH), an ester group (-C(=O)OR, wherein R is a C1 to C6 alkyl group or a C6 to C12 aryl group), a carboxyl group (-COOH) or a salt thereof (-C(=O)OM, wherein M is an organic or inorganic cation), a sulfonic acid group (-SOsH) or a salt thereof (-SOsM, wherein M is an organic or inorganic cation), a phosphoric acid group ($-PO_3H_2$) or a salt thereof ($-POsMH$ or $-PO_3M_2$, wherein M is an organic or inorganic cation), or a combination thereof.

As used herein, when a definition is not otherwise provided, "hydrocarbon" and "hydrocarbon group" refers to a compound or a group including carbon and hydrogen (e.g., alkyl, alkenyl, alkynyl, or aryl group). The hydrocarbon group may be a group having a monovalence or more formed by removal of a, e.g., one or more, hydrogen atoms from alkane, alkene, alkyne, or arene. In the hydrocarbon or hydrocarbon group, a, e.g., at least one, methylene may be replaced by an oxide moiety, a carbonyl moiety, an ester moiety, -NH-, or a combination thereof. Unless otherwise stated to the contrary, the hydrocarbon compound or hydrocarbon group (alkyl, alkenyl, alkynyl, or aryl) may have 1 to 60, 2 to 32, 3 to 24, or 4 to 12 carbon atoms.

As used herein, when a definition is not otherwise provided, "aliphatic" refers to a saturated or unsaturated linear or branched hydrocarbon group. An aliphatic group may be an alkyl, alkenyl, or alkynyl group, for example.

As used herein, when a definition is not otherwise provided, "alkyl" refers to a linear or branched saturated monovalent hydrocarbon group (methyl, ethyl hexyl, etc.).

As used herein, when a definition is not otherwise provided, "alkenyl" refers to a linear or branched monovalent hydrocarbon group having a carbon-carbon double bond.

As used herein, when a definition is not otherwise provided, "alkynyl" refers to a linear or branched monovalent hydrocarbon group having a carbon-carbon triple bond.

As used herein, when a definition is not otherwise provided, "aryl" refers to a group formed by removal of a, e.g., at least one, hydrogen from an arene (e.g., a phenyl or naphthyl group).

As used herein, when a definition is not otherwise provided, "hetero" refers to including 1 to 3 heteroatoms, e.g., N, O, S, Si, P, or a combination thereof.

As used herein, a nanostructure is a structure having at least one region or characteristic dimension with a dimension of less than or equal to about 500 nm. A dimension (or an average) of the nanostructure(s) may be less than or equal to about 300 nm, less than or equal to about 250 nm, less than or equal to about 150 nm, less than or equal to about 100 nm, less than or equal to about 50 nm, or less than or equal to about 30 nm. The structure may have any shape. The nanostructure may include a nanowire, a nanorod, a nanotube, a branched nanostructure, a nanotetrapod, a nanotripod, a nanobipod, a nanocrystal, a nanodot, a multi-pod type shape such as at least two pods, or the like and is not limited thereto. The nanostructure can be, e.g., substantially crystalline, substantially monocrystalline, polycrystalline, (for example, at least partially) amorphous, or a combination thereof.

The term "quantum dot" (or "dot") refers to a nanocrystal that exhibits quantum confinement or exciton confinement. The quantum dot is a type of light emitting nanostructure. As used herein, a shape of the "quantum dot' may not particularly limited.

The light emitting device includes a first electrically conducting layer, a second electrically conducting layer (e.g., spaced from one another or facing each other), and a light-emitting layer disposed between the first electrically conducting layer and the second electrically conducting layer. The light-emitting layer (or a light emitting film in another aspect of the invention) includes light emitting nanostructures. The light emitting layer is configured to emit green light. The light emitting layer (or a light emitting film of another aspect of the invention) does not include cadmium, lead, or a combination thereof.

The green light or the light emitting nanostructure may have a (maximum) luminescent peak wavelength of greater than or equal to 490 nm, greater than or equal to about 500 nm, greater than or equal to about 510 nm, greater than or equal to about 515 nm, or greater than or equal to about 520 nm.

The green light or the light emitting nanostructure may have a (maximum) luminescent peak wavelength of less than or equal to 580 nm, less than or equal to about 570 nm, less than or equal to about 565 nm, less than or equal to about 560 nm, less than or equal to about 555 nm, less than or equal to about 550 nm, or less than or equal to about 545 nm.

The green light (or the light emitting nanostructures) may have a full width at half maximum of less than or equal to about 40 nm, less than or equal to about 35 nm, or less than or equal to about 30 nm and greater than or equal to about 5 nm, greater than or equal to about 10 nm, or greater than or equal to about 15 nm.

The light emitting nanostructures do not include cadmium, lead, or a combination thereof. The light emitting nanostructures include a first semiconductor nanocrystal including a Group III-V compound and a second semiconductor nanocrystal including a zinc chalcogenide. The Group III-V compound includes indium, phosphorus, and optionally zinc. The zinc chalcogenide includes zinc, selenium, and sulfur. The light emitting nanostructures may include quantum dots.

The light emitting nanostructures exhibit a zinc blende structure. The light emitting nanostructures may show, e.g., exhibit, a cubic feature.

Accordingly, in a two dimensional image obtained by an electron microscopy analysis, the light emitting nanostructures show, e.g., exhibit, an average value of squareness defined by the following equation of greater than or equal to 0.8:

$$\text{Squareness} = A/C$$

wherein A is an area of a given light emitting nanostructure in the two dimensional image, and C is an area of a smallest square that covers the area of a given light emitting nanostructure.

In a two dimensional image obtained by a transmission electron microscopy analysis, the light emitting nanostructures may show, e.g., exhibit, a cubicity defined by the following equation of greater than or equal to about 0.75:

$$B/A' = \text{cubicity}$$

wherein A' is a total area of the light emitting nanostructures in the two dimensional image, and B is an area (e.g., a total area) of (100) planes of the light emitting nanostructures in the two dimensional image.

With regard to the squareness, the area C may be determined by $c^2$ wherein c is a length of the smallest square. The smallest square may be a circumscribed square.

Determination of the smallest square or the length of the smallest square may be readily and clearly made according to a given particle shape. For a shape of a circle or an ellipse, the c may be a diameter or a length of the major axis. For a shape of a rectangle, the c may be a length of a longer side length.

The two dimensional image may be a high resolution transmission electron microscopy image wherein a resolution may be from about 0.2 nm to about 0.08 nm and the magnification may be from about x2,000,000 to about x10,000,000, about x3,000,000 to about ×7,000,000, for example, 5,000,000 times.

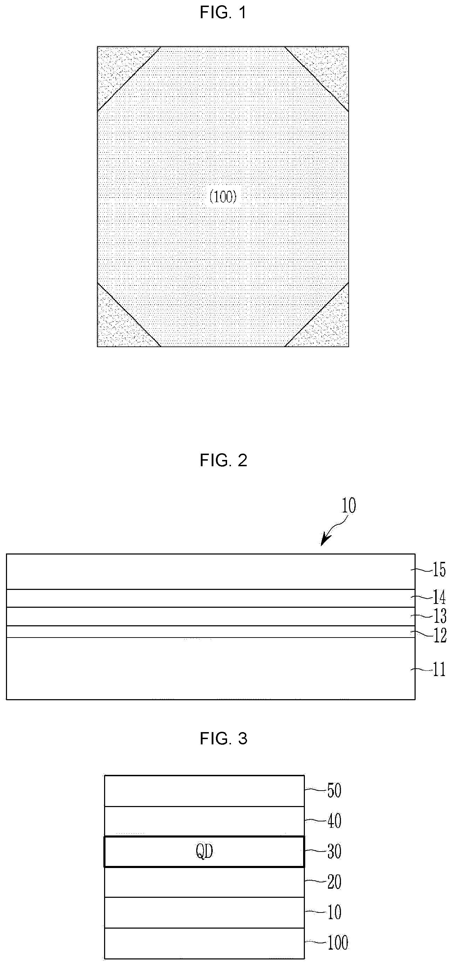

High-resolution transmission electron microscopy (HRTEM) is an imaging mode of specialized transmission electron microscopes that allows for direct imaging of the atomic structure of a given nanostructure. The HRTEM is substantially identical to transmission electron microscopy (TEM) imaging except that the magnifications used are high enough to see the lattice spacing of inorganic materials (typically on the order of several angstroms (Å)). Although such lattice spacings can easily be recorded onto film at moderate magnifications. The cubicity will be further explained in reference to FIG. 1.

In an aspect, an electroluminescent device (hereinafter, referred to as "light emitting device.") includes a first electrically conducting layer (e.g., a first electrode, as used herein the electrically conducting layer and the electrode are terms that can be interchangeably used), a second electrically conducting layer (e.g., a second electrode), for example, spaced from one another or facing each other, and a light-emitting layer (e.g., a light emitting film, as used herein, the phrases "light emitting layer" and "light emitting film" can be used interchangeably) disposed between the first electrically conducting layer and the second electrically conducting layer and including light emitting nanostructures.

The light emitting device may exhibit a maximum EQE of greater than or equal to about 10%, and the light emitting device may show, e.g., exhibit, a maximum luminance of greater than or equal to about 300,000 cd/m$^2$. The light emitting nanostructures include a first semiconductor nanocrystal including a Group III-V compound and a second semiconductor nanocrystal including a zinc chalcogenide, wherein the Group III-V compound includes indium, phosphorus, and optionally zinc, and the zinc chalcogenide includes zinc, selenium, and sulfur. Hereinafter, a light-emitting device according to an embodiment is explained with reference to the drawings.

FIG. 2 is a cross-sectional representation of a light-emitting device according to an embodiment. Referring to FIG. 2, the light-emitting device 10 according to an embodiment includes electrodes (first electrode 11 and second electrode 15) spaced apart and each with a surface opposite the other, and a light-emitting layer 13 including a plurality of quantum dots disposed between the electrodes. A charge auxiliary layer may be disposed between the light-emitting layer 13 and the electrodes. If the first electrode 11 is an anode and the second electrode 15 is a cathode, a hole auxiliary layer 12 that assists movement (transport/injection) of holes may be disposed between the first electrically conducting layer and the light-emitting layer and an electron auxiliary layer 14 that assists movement (transport/injection) of electrons may be disposed between the second electrically conducting layer and the light-emitting film.

The light-emitting device may include a substrate (not shown). The substrate may be disposed on the first electrode 11 (e.g., a major surface of the first electrode 11) or may be disposed on the second electrode 15 (e.g., a major surface of the second electrode 15). The substrate may be disposed on an opposite side of the first electrically conducting layer (e.g., under the first electrically conducting layer) in FIG. 2. The substrate may be disposed on an opposite side of the second electrode 15 (e.g., above the second electrically conducting layer) in FIG 2. The substrate may be a substrate including an insulation material (e.g., insulating transparent substrate). The substrate may include glass; various polymers such as polyester (e.g., polyethylene terephthalate (PET), polyethylene naphthalate (PEN)), polycarbonate, poly(meth)acrylate, polyimide, and poly(amide-imide); polysiloxane (e.g., polydimethylsiloxane (PDMS)); inorganic materials such as silicon, silicon oxide, and $Al_2O_3$; or a combination thereof, but is not limited thereto. Herein "transparent" refers to transmittance for light in a predetermined wavelength (e.g., light emitted from the quantum dots) of greater than or equal to about 85%, for example, greater than or equal to about 88%, greater than or equal to about 90%, greater than or equal to about 95%, greater than or equal to about 97%, or greater than or equal to about 99%. A thickness of the substrate may be appropriately selected considering a substrate material, and the like, but is not particularly limited. The transparent substrate may have flexibility. The substrate may be omitted.

One of the first electrode 11 or the second electrode 15 may be an anode and the other may be a cathode. For example, the first electrode 11 may be an anode, and the second electrode 15 may be a cathode and vice versa.

The first electrode 11 may be made of a conductor, for example a metal, a conductive metal oxide, or a combination thereof. The first electrode 11 may be for example made of a metal, such as nickel, platinum, vanadium, chromium, copper, zinc, and gold, or an alloy thereof; a conductive metal oxide, such as zinc oxide, indium oxide, tin oxide, indium tin oxide (ITO), indium zinc oxide (IZO), or fluorine doped tin oxide; or a combination of metal and oxide, such as ZnO and Al or $SnO_2$ and Sb; and the like, but is not limited thereto. The first electrically conducting layer may include a transparent conductive metal oxide, for example, indium tin oxide. A work function of the first electrically conducting layer may be higher than a work function of the second electrically conducting layer that will be described herein. A work function of the first electrically conducting layer may be lower than a work function of the second electrically conducting layer that will be described herein.

The second electrode 15 may be made of a conductor, for example a metal, a conductive metal oxide, a conductive polymer, or a combination thereof. The second electrode 15 may be for example a metal, such as aluminum, magnesium, calcium, sodium, potassium, titanium, indium, yttrium, lithium, gadolinium, silver, tin, lead, cesium, or barium, or an alloy thereof; a multi-layer structured material, such as LiF/Al, $Li_2O$/Al, Liq/Al, LiF/Ca, and $BaF_2$/Ca, but is not limited thereto. The second electrically conducting layer may include a transparent conductive metal oxide, such as indium tin oxide. The conductive metal oxide is the same as described herein.

A work function of the first electrode 11 may be from about 4.5 eV to about 5.0 eV (e.g., from about 4.6 eV to about 4.9 eV), and a work function of the second electrode 15 may be greater than or equal to about 4.0 eV and less than or equal to about 4.8 eV (e.g., for example, from about 4.1 eV to about 4.7 eV, from about 4.3 eV to about 4.5 eV).

A work function of the second electrode 15 may be from about 4.5 eV to about 5.0 eV (e.g., from about 4.6 eV to about 4.9 eV), and a work function of the first electrode 11 may be greater than or equal to about 4.0 eV and less than or equal to about 4.8 eV (e.g., for example, from about 4.1 eV to about 4.7 eV, from about 4.3 eV to about 4.5 eV).

The first electrode 11, the second electrode 15, or each of the first electrode 11 and the second electrode 15 may be a light-transmitting electrode, and the light-transmitting electrode may be for example made of a conductive oxide such as a zinc oxide, indium oxide, tin oxide, indium tin oxide (ITO), indium zinc oxide (IZO), or fluorine doped tin oxide, or a metal thin layer of a single layer or a multilayer. If one of the first electrode 11 or the second electrode 15 is a non-light-transmitting electrode, the electrode may be made of for example an opaque conductor such as aluminum (Al), silver (Ag), or gold (Au).

A thickness of the electrodes (the first electrically conducting layer, the second electrically conducting layer, or each of the first electrically conducting layer and the second electrically conducting layer) is not particularly limited and may be appropriately selected considering device efficiency. For example, the thickness of the electrodes may greater than or equal to about 5 nanometers (nm), for example, greater than or equal to about 50 nm, or greater than or equal to about 100 nm. For example, the thickness of the electrodes may be less than or equal to about 100 $\mu$m, for example, less than or equal to about 10 um, less than or equal to about 1 um, less than or equal to about 900 nm, less than or equal to about 500 nm, less than or equal to about 400 nm, less than or equal to about 300 nm, less than or equal to about 200 nm, or less than or equal to about 100 nm.

The emissive layer 13 includes (e.g., a plurality of) light emitting nanostructures. A light emitting nanostructure such as a quantum dot or a semiconductor nanocrystal may absorb energy (e.g., an electrical energy or a photo-energy) from an excitation source to be excited and may emit light of a wavelength corresponding to a bandgap energy thereof. The bandgap energy of the light emitting nanostructure may vary with a size, composition, or a combination thereof of the nanocrystal. The light emitting nanostructures may have a narrower bandgap energy, and an increased luminous wavelength as their sizes increase.

The light emitting nanostructures draw attention and find their use as a light emitting material in various fields such as a display device, an energy device, or a bio light emitting device.

The light emitting nanostructures such as a quantum dot may achieve increased light emitting efficiency and improved color reproducibility. A light emitting device using electrical energy as an excitation source (hereinafter, which can be referred to as an electroluminescent device) or a display device including the same may be driven without an external light source. In the electroluminescent device, the electrical conductor (e.g., a first electrode and a second electrode) may provide electrons and holes, which are injected into a light emitting layer and recombined therein to form exciton and from the exciton, an energy can be emit in a form of light.

Quantum dots including a toxic heavy metal such as cadmium, lead, mercury, or a combination thereof may show, e.g., exhibit, better properties and greater stability than a cadmium free quantum dot. However, cadmium may cause environment/health problems and is one of the restricted elements via Restriction of Hazardous Substances Directive (RoHS) in many countries. Accordingly, development of a cadmium-free quantum dot that may exhibit improved electroluminescence properties (e.g., when being used in an electroluminescent device) such as a desired wavelength, a narrowed full width at half maximum (FWHM), and increased luminance can be a challenging task in the art.

A nanostructure or a semiconductor nanocrystal particle (also referred to as "quantum dot" herein) including a Group III-V compound may be a cadmium free light emitting nanostructure that may be applied, e.g., used, in a variety of electronic devices such as a display device for example, in a form of a film. According to the research of the present inventors, indium phosphide based quantum dots may be desired to have a tiny size of less than about 7 nm for green light emission.

The present inventors have also found that the indium phosphide based quantum dots emitting green light may not achieve a desired level of electroluminescent properties. Without wishing to be bound by any theory, it is believed that such a small size desired for green light emission may include a relatively large surface area and a presence of a relatively large amount of an organic ligand thereon. Without wishing to be bound any theory, it is believed that unlike a photoluminescent type device using light as an excitation source, in the electroluminescent device, such a large amount of the organic ligand may play a considerable role of resistance, whereby the properties of the device can be limited and the durability of the device may also be adversely affected.

It may be possible to consider an increase of the light emitting nanostructure, as a measure of addressing such a drawback. The present inventors have also found that it is very challenging task for an indium phosphide based nanostructure of emitting green light to achieve a uniform size growth and that it is also very difficult for the large sized green light emitting nanostructure to realize, e.g., exhibit, a desired level of properties when applied, e.g., used, in an electroluminescent device.

According to the research of the present inventors, an indium phosphide based quantum dot including a relatively increased size and emitting green light may tend to have a distorted particle shape and it may be difficult to achieve a uniform particle size distribution. The present inventors have found that the large sized quantum dots including an indium phosphide and emitting green light may not show, e.g., exhibit, a desired level of properties such as the emission efficiency, luminance, and reliability at the same time even when the large sized quantum dots including an indium phosphide and emitting green light show, e.g., exhibit, enhanced properties in a solution state. Without wishing to be bound by any theory, it is believed that when the second semiconductor nanocrystal (e.g., a shell) is formed on the indium phosphide core to provide the light emitting nanocrystal, a decrease in an amount of the second semiconductor nanocrystal may cause an adverse effect on a particle size distribution and a luminous property thereof, while an increase in the amount of the second semiconductor nanocrystal may lead to a shape distortion due to a difference of a crystal growth rate and a lattice mismatch. Accordingly, there still remains much room for improvement of properties for an electroluminescent device including conventional quantum dots emitting green light.

The light emitting nanostructure may be prepared by a method disclosed herein (for example, involving an increased reaction temperature and a controlled manner in terms of injection times and an amount of precursor for each injection). Without wishing to be bound by any theory, it is believed that in the method disclosed herein, a particle growth may be accomplished in a same crystal plane substantially without a defect. In addition, a mole ratio between the first semiconductor nanocrystal and the second semiconductor nanocrystal or a mole ratio between the zinc chalcogenides may be controlled to change the lattice strain and the lattice mismatch. Accordingly, the nanostructures prepared therefrom may exhibit an increased cubic shaped feature (e.g., increased cubicity or squareness), and this shape feature is believed to result in the improvement of the electroluminescent properties in the application for the device.

A light emitting device may include a light emitting film including light emsitting nanostructure including an indium phosphide and may achieve an improved level of properties for an electroluminescent device at the same time.

In an aspect of the invention, the light emitting nanostructures include a first semiconductor nanocrystal including a Group III-V compound and a second semiconductor nanocrystal including a zinc chalcogenide. The Group III-V compound includes indium, phosphorus, and optionally zinc. The zinc chalcogenide includes zinc, selenium, and sulfur.

In an aspect of the invention, the light emitting nanostructures exhibit a zinc blende structure and may show, e.g., exhibit, a cubic shaped feature. In an aspect of the invention, the light emitting nanostructures in the light emitting layer exhibit a zinc blende structure, and may show, e.g., exhibit, a cubic shaped feature, wherein in a two dimensional image obtained by an electron microscopy analysis, an average value of squareness of the light emitting nanostructures defined by the following equation is greater than or equal to 0.8:

$$\text{Squareness} = A/C$$

wherein A is an area of a given light emitting nanostructure in the two dimensional image, and C is an area of a smallest square that covers the area of a given light emitting nanostructure.

Accordingly, in a two dimensional image obtained by a transmission electron microscopy analysis, the light emitting nanostructures may show, e.g., exhibit, a cubicity defined by the following equation of greater than or equal to about 0.8:

$$B/A' = \text{cubicity}$$

wherein A' is a total area of the light emitting nanostructures in the two dimensional image, and B is an area (e.g., a total area) of (100) planes of the light emitting nanostructures in the two dimensional image.

For given particles included in a light emitting layer, a transmission electron microscopy analysis is carried out to obtain a two dimensional image of each of the given particle(s), using a commercially available TEM equipment. An area of the given particle A or a total area of the given particles A' in the two dimensional TEM image may be easily and readily calculated, respectively, for example, by using a commercially available image analysis program such as image J or an image handling program for example, universally available or compatible with operating system or hardware, such as "Paint" from Microsoft Windows. The area corresponding to (100) plane can be calculated using a high resolution transmission electron microscope and determine an area B of crystal domain region observed in a direction of 100 (e.g., [100] direction). The area B is divided with the area A' to provide the cubicity (see FIG. 1). For the measurement of the squareness, the smallest square that covers the area of a given light emitting nanostructure (e.g., a circumscribed square) may be determined, and the area thereof, the C may be calculated by $c^2$ wherein c is a length of the smallest square. The smallest square may be readily and reproducibly determined for each of the particles in any commercially available image handling computer program (for example, universally provided by Microsoft Windows). The area A is divided with the area C to provide the squareness.

In the light emitting layer of the invention, the light emitting nanostructures have a first semiconductor nanocrystal of InP or InZnP and a second semiconductor nanocrystal including a zinc chalcogenide, for example, in a core shell structure, and by adopting the preparation method disclosed herein, the light emitting nanostructures show, e.g., exhibit, an increased cubic shaped feature (e.g., a squareness or a cubicity) disclosed herein even together with an increased size.

The present inventors have surprisingly found that when a second semiconductor nanocrystal including a zinc chalcogenide is formed on a first semiconductor nanocrystal including an indium phosphide optionally including zinc, a growth rate may vary with a site in a given particle as an amount of the second semiconductor nanocrystal and this may result in a shape distortion for example due to a lattice mismatch between the first semiconductor nanocrystal and the second semiconductor nanocrystal.

The present inventors have also found that the quantum dots including InP (e.g., InZnP) and emitting green light may show, e.g., exhibit, an increased solidity or circularity in light of a shape factor but even with the increased solidity or circularity, the green light emitting quantum dots may not show, e.g., exhibit, a desired level of the combination of the electroluminescent properties (e.g., a high EQE and a high luminance) when being applied, e.g., used, in an electroluminescent device. The solidity and the circularity are a shape factor that is universally defined and can be readily and reproducibly determined by using an image analysis program or code.

For example, as used herein, the circularity may be determined by using a two dimensional image obtained by an electron microscopy analysis and using the following equation referring to image J user guide (v 1.46r):

$$4 \pi \times \{(\text{Area})/(\text{Perimeter})^2\}$$

The circularity may be 1 for a perfect circle and as the circularity is closer to zero (0), a given shape is an increasingly elongated shape.

As used herein, a solidity of a nanostructure can be determined by dividing "a measured area" of the nanostructure with "a convex hull area" in a TEM analysis thereof. The convex hull may be defined as the smallest convex set of points in which a set of all points constituting a two dimensional image of a given quantum dot obtained by an electron microscopic analysis is contained.

In an aspect of the invention, by having the cubic shaped features (e.g., the squareness or the cubicity) as disclosed herein together with the disclosed composition, and optionally an increased size and improved size distribution, the indium phosphide based nanostructures may achieve the combined electroluminescent properties that are improved to a desired level in an electroluminescent device. The aforementioned nanostructures may be obtained by the method disclosed herein. The synthesis of the aforementioned nanostructures may involve changing (e.g., increasing) a temperature for the formation of the second semiconductor nanocrystal and adopting an intermittent injection manner of precursors for the second semiconductor nanocrystal several times (e.g., at least two times, three times, or more) optionally wherein an injection amount for each precursor is changed (e.g., increased) and whereby the formation or the growth of the nanocrystal occurs on a desired crystal facet (e.g., the same crystal facet).

Accordingly, the nanocrystal structures included in the light emitting layer of a device include the first semiconductor nanocrystal and the second semiconductor nanocrystal in such a manner that a lattice strain and a lattice mismatch between the first semiconductor nanocrystal and the second semiconductor nanocrystal or between the zinc selenide and the zinc sulfide included in the second semiconductor nanocrystal may be controlled within a desired extent and thus the resulting nanocrystal structures may show, e.g., exhibit, the cubic shaped features (e.g., the squareness or the cubicity) that cannot be achieved for conventional green light emitting, indium phosphide based nanostructures. In addition, during the synthesis of the final nanostructures for the inclusion in the light emitting layer of the device, by adopting the aforementioned crystal growth strategy, the nanocrystal structures thus obtained may emit green light while having relatively increased sizes together with an improved particle size distribution. In addition, the nanostructures having the composition disclosed herein may exhibit the cubic shaped features (e.g., the squareness or the cubicity) for example together with a relatively increased size, an improved particle size distribution, or a combination thereof, achieving a desired level of the combined electroluminescent properties (e.g., the max EQE and max luminance) when being included in an electroluminescent device. Without wishing to be bound by any theory, it is believed that the nanostructures may form the light emitting layer or the light emitting film to have an increased packing density, which may further contribute to achieving the desired combination of the electroluminescent properties.

The cubic shaped feature, e.g., the cubicity of the light emitting structures may be greater than or equal to about 0.7, greater than or equal to about 0.71, greater than or equal to about 0.72, greater than or equal to about 0.73, greater than or equal to about 0.74, greater than or equal to about 0.75, greater than or equal to about 0.76, greater than or equal to about 0.77, greater than or equal to about 0.78, greater than or equal to about 0.79, greater than or equal to about 0.8, greater than or equal to about 0.81, greater than or equal to about 0.82, greater than or equal to about 0.83, greater than or equal to about 0.84, greater than or equal to about 0.85, greater than or equal to about 0.86, greater than or equal to about 0.87, greater than or equal to about 0.88, greater than or equal to about 0.89, or greater than or equal to about 0.9. The cubicity of the light emitting structures may be less than or equal to about 1, less than or equal to about 0.99, less than or equal to about 0.98, less than or equal to about 0.97, less than or equal to about 0.96, or less than or equal to about 0.95.

The squareness of the light emitting structures is greater than or equal to 0.8, and may be greater than or equal to about 0.81, greater than or equal to about 0.82, greater than or equal to 0.83, greater than or equal to about 0.84, greater than or equal to 0.85, greater than or equal to about 0.86, greater than or equal to about 0.87, greater than or equal to about 0.88, greater than or equal to about 0.89, or greater than or equal to about 0.9. The squareness of the light emitting structures may be less than or equal to about 1, less than or equal to about 0.99, less than or equal to about 0.98, less than or equal to about 0.97, less than or equal to about 0.96, or less than or equal to about 0.95.

In an embodiment, the light emitting nanostructures may be configured to emit green light while having an increased average size. In an embodiment, the average size of the light emitting nanostructures may be greater than or equal to 7 nm, greater than or equal to about 7.1 nm, greater than or equal to about 7.2 nm, greater than or equal to about 7.3 nm, greater than or equal to about 7.4 nm, greater than or equal to about 7.5 nm, greater than or equal to about 7.6 nm, greater than or equal to about 7.7 nm, greater than or equal to about 7.8 nm, greater than or equal to about 7.9 nm, greater than or equal to about 8 nm, greater than or equal to about 8.1 nm, greater than or equal to about 8.2 nm, greater than or equal to about 8.3 nm, greater than or equal to about 8.4 nm, greater than or equal to about 8.5 nm, greater than or equal to about 8.6 nm, greater than or equal to about 8.7 nm, greater than or equal to about 8.8 nm, greater than or equal to about 8.9 nm, or greater than or equal to about 9 nm. The average size of the light emitting nanostructures may be less than or equal to about 20 nm, less than or equal to about 19 nm, less than or equal to about 18 nm, less than or equal to about 17 nm, less than or equal to about 16 nm, less than or equal to about 15 nm, less than or equal to about 14 nm, less than or equal to about 13 nm, less than or equal to about 12 nm, less than or equal to about 11 nm, or less than or equal to about 10 nm.

In an embodiment, the light emitting structures may show, e.g., exhibit, a relatively uniform particle size distribution, which may be less than or equal to 10%, less than or equal to about 9%, less than or equal to about 8%, or less than or equal to about 7% of the average size thereof.

The light emitting nanostructures may have a surface predominant with (100) face of the crystal, and in the light emitting device or in the light emitting film, the light emitting structures may have the predominant crystal facet on a surface thereof, whereby surface properties (e.g., a metal rich surface or an organic ligand rich surface) of the light emitting nanostructures may become more uniform.

The nanostructures (e.g., the quantum dots) may be prepared with a process enabling a crystal growth at a controlled crystal facet, which may reduce a lattice defect and achieve a crystallographically improved quality.

Without wishing to be bound by any theory, it is believed that the improved crystal quality may affect the luminance properties of the quantum dots, and may be translated into a suppressed/limited surface trap emission. The trap emission refers to an emission other than the band edge mission (i.e., the luminous emission involved in the balance band and the conduction band). The degree of the trap emission may be confirmed by a low temperature photoluminescent analysis (e.g., carried out at a temperature of about 77 K). The nanocrystals may exhibit a full width at half maximum of less than or equal to about 11 nm, less than or equal to about 10 nm, less than or equal to about 9 nm, or less than or equal to about 8 nm.

In an embodiment, in the light emitting nanostructures or the light emitting layer, a mole ratio of zinc with respect to indium (Zn:In) may be greater than about 39:1, greater than or equal to about 40:1, greater than or equal to about 41:1, greater than or equal to about 42:1, greater than or equal to about 43:1, greater than or equal to about 44:1, greater than or equal to about 45:1, greater than or equal to about 46:1, greater than or equal to about 47:1, greater than or equal to about 48:1, greater than or equal to about 49:1, greater than or equal to about 50:1, greater than or equal to about 51:1, greater than or equal to about 52:1, greater than or equal to about 53:1, greater than or equal to about 54:1, greater than or equal to about 55:1, or greater than or equal to about 56:1. The mole ratio of zinc with respect to indium (Zn:In) may be less than or equal to about 92:1, less than or equal to about 91:1, less than or equal to about 90:1, less than or equal to about 89:1, less than or equal to about 85:1, less than or equal to about 80:1, less than or equal to about 75:1, less than or equal to about 70:1, less than or equal to about 69:1, less than or equal to about 68:1, less than or equal to about 67:1, less than or equal to about 66:1, less than or equal to about 65:1, less than or equal to about 64:1, less than or equal to about 63:1, less than or equal to about 62:1, less than or equal to about 61:1, less than or equal to about 60:1, or less than or equal to about 59:1. In an embodiment, the mole ratio of zinc with respect to indium (Zn:In) may be greater than or equal to 43. The mole ratio of zinc with respect to indium (Zn:In) may be greater than or equal to about 49:1, greater than or equal to about 50:1, greater than or equal to about 50.5:1, greater than or equal to about 51:1, or greater than or equal to about 52:1. The mole ratio of zinc with respect to indium (Zn:In) may be from about 49:1 to about 65:1, from about 49.5:1 to about 63.5:1, from about 55:1 to about 63:1, from about 57:1 to about 62.5:1, or a combination thereof.

An amount of components included in the quantum dot as described herein may be determined through, e.g., with, an appropriate analysis tool (e.g., an inductively coupled plasma atomic emission spectroscopy (ICP-AES), an X-ray photoelectron spectroscopy (XPS), an ion chromatography, a Transmission electron microscopy energy-dispersive X-ray spectroscopy (TEM-EDS), or the like).

In an embodiment, in the light emitting nanostructures or the light emitting layer, a mole ratio of sulfur with respect to indium (S:In) may be greater than or equal to about 11:1, greater than or equal to 11.5:1, greater than or equal to about 12:1, greater than or equal to about 12.3:1, or greater than or equal to about 12.5:1. The mole ratio of sulfur with respect to indium (S:In) may be less than or equal to about 19:1, less than or equal to about 18:1, less than or equal to about 17:1, less than or equal to about 16:1, less than or equal to about 15:1, less than or equal to about 14:1, less than or equal to about 13.5:1, less than or equal to about 13:1, less than or equal to about 12.8:1, or less than or equal to about 12.5:1.

A mole ratio of selenium with respect to indium (Se:In) may be greater than or equal to about 29:1, greater than or equal to about 30:1, greater than or equal to about 35:1, greater than or equal to about 37:1, greater than or equal to about 37.5:1, greater than or equal to about 38:1, greater than or equal to about 38.5:1, or greater than or equal to about 39:1. A mole ratio of selenium with respect to indium (Se:In) may be less than or equal to about 75:1, less than or equal to about 74:1, less than or equal to about 73:1, less than or equal to about 72:1, less than or equal to about 71:1, less than or equal to about 70:1, less than or equal to about 69:1, less than or equal to about 68:1, less than or equal to about 67:1, less than or equal to about 66:1, less than or equal to about 65:1, less than or equal to about 64:1, less than or equal to about 63:1, less than or equal to about 62:1, less than or equal to about 61:1, less than or equal to about 60:1, less than or equal to about 59:1, less than or equal to about 58:1, less than or equal to about 57:1, less than or equal to about 56:1, less than or equal to about 55:1, less than or equal to about 54:1, less than or equal to about 53:1, or less than or equal to about 52:1.

In an embodiment, in the light emitting nanostructures or the light emitting layer, a mole ratio of indium with respect to a total sum of sulfur and selenium {In:(Se+S)} may be less than or equal to 0.04:1, less than or equal to about 0.039:1, less than or equal to about 0.038:1, less than or equal to about 0.037:1, less than or equal to about 0.036:1, less than or equal to about 0.035:1, less than or equal to about 0.034:1, less than or equal to about 0.033:1, less than or equal to about 0.032:1, less than or equal to about 0.031:1, less than or equal to about 0.03:1, less than or equal to about 0.029:1, less than or equal to about 0.028:1, less than or equal to about 0.027:1, less than or equal to about 0.026:1, less than or equal to about 0.025:1, less than or equal to about 0.024:1, or less than or equal to about 0.0235:1. The mole ratio of indium with respect to a total sum of sulfur and selenium {In:(Se+S)} may be greater than or equal to about 0.001:1, greater than or equal to about 0.005:1, greater than or equal to about 0.01:1, or greater than or equal to about 0.015:1.

In an embodiment, in the light emitting nanostructures or the light emitting layer, a mole ratio of zinc with respect to a total sum of sulfur and selenium {Zn:(Se+S)} may be less than or equal to about 2:1, less than or equal to about 1.9:1, less than or equal to about 1.8:1, less than or equal to about 1.7:1, less than or equal to about 1.6:1, less than or equal to 1.5:1, less than or equal to about 1.4:1, less than or equal to about 1.3:1, less than or equal to about 1.2:1, less than or equal to about 1.19:1, less than or equal to about 1.18:1, less than or equal to about 1.17:1, less than or equal to about 1.16:1, less than or equal to about 1.15:1, less than or equal to about 1.14:1, less than or equal to about 1.13:1, less than or equal to about 1.12:1, or less than or equal to about 1.1:1. The mole ratio of zinc with respect to a total sum of sulfur and selenium {Zn:(Se+S)} may be greater than or equal to about 0.8:1, greater than or equal to about 0.9:1, or greater than or equal to about 1:1.

In an embodiment, a mole ratio of sulfur with respect to selenium (S:Se) may be less than or equal to 0.5:1, less than or equal to about 0.49:1, less than or equal to about 0.48:1, less than or equal to about 0.47:1, less than or equal to about 0.46:1, less than or equal to about 0.45:1, less than or equal to about 0.44:1, less than or equal to about 0.43:1, less than or equal to about 0.42:1, less than or equal to about 0.41:1, less than or equal to about 0.4:1, less than or equal to about 0.39:1, less than or equal to about 0.38:1, less than or equal to about 0.37:1, less than or equal to about 0.36:1, less than or equal to about 0.35:1, less than or equal to about 0.34:1, less than or equal to about 0.33:1, or less than or equal to about 0.32:1. A mole ratio of sulfur with respect to selenium (S:Se) may be greater than or equal to about 0.15:1, greater than or equal to about 0.2:1, greater than or equal to about 0.21:1, greater than or equal to about 0.22:1, greater than or equal to about 0.23:1, greater than or equal to about 0.24:1, greater than or equal to about 0.25:1, greater than or equal to about 0.26:1, greater than or equal to about 0.27:1, or greater than or equal to about 0.28:1.

At least a portion of (or an entire of) the surface of the core (e.g., the first semiconductor nanocrystal) of the light emitting nanostructures may include the second semiconductor nanocrystal. The entire of the surface of the core may include the second semiconductor nanocrystal.

The light emitting nanostructures or the quantum dots may have a core shell structure including a core and a shell disposed on the core. In the core shell structure, the first semiconductor nanocrystal may be included in the core and the second semiconductor nanocrystal may be included in the shell.

The first semiconductor nanocrystal or the core(s) may include an indium phosphide, an indium zinc phosphide, or a combination thereof. The core may have a size (or an average size) of greater than or equal to about 1 nm, greater than or equal to about 1.5 nm, greater than or equal to about 2 nm, or greater than or equal to about 2.5 nm. The core may have a size (or an average size) of less than or equal to about 5 nm, less than or equal to about 4 nm, less than or equal to about 3.5 nm, less than or equal to about 3 nm, or less than or equal to about 2.7 nm.

The second semiconductor nanocrystal or the shell may include a zinc selenide, a zinc sulfide, or a combination thereof. The second semiconductor nanocrystal or the shell may include a zinc selenide sulfide. The shell or each of the shell layers in the multi-layered shell may include a gradient alloy having a composition varying in a direction of a radius, e.g., a radial direction from the core toward an outermost surface of the quantum dot. The shell or the second semiconductor nanocrystal may have a concentration of sulfur increasing in a direction of a radius, e.g., a radial direction from the core toward an outermost surface of the nanostructure. In the shell or the second semiconductor nanocrystal, a concentration of sulfur may increase in a direction of a radius, e.g., a radial direction from the core toward an outermost surface of the nanostructure.

The shell may be a multi-layered shell including two or more layers. In the multi-layered shell, adjacent two layers may have different compositions from each other. The multi-layered shell may include a first shell layer including zinc, selenium, and optionally sulfur, and a second shell layer disposed on the first shell layer, having a different composition from the first shell layer, and including zinc, sulfur, and optionally selenium. The first shell layer may be disposed directly on the core. The first shell layer may include a zinc selenide. The second shell layer may include a zinc sulfide. The first shell layer may include ZnSe, ZnSeS, or a combination thereof. The first shell layer may or may not include sulfur. The second shell layer may include ZnS, ZnSeS, or a combination thereof. The second shell layer may be an outermost shell layer of the nanostructure.

A thickness of the shell may be greater than or equal to about 1 nm, greater than or equal to about 1.5 nm, greater than or equal to about 2 nm, greater than or equal to about 2.3 nm, greater than or equal to about 2.5 nm, greater than or equal to about 2.7 nm, greater than or equal to about 3 nm, or greater than or equal to about 3.1 nm, or greater than or equal to about 3.3 nm. A thickness of the shell may be less than or equal to about 6 nm, less than or equal to about 5 nm, less than or equal to about 4 nm, or less than or equal to about 3.5 nm.

In the multi-layered shell, a thickness of the first shell layer (for example including a zinc selenide) may be greater than or equal to about 0.3 nm, greater than or equal to about 0.5 nm, greater than or equal to about 0.7 nm, greater than or equal to about 0.9 nm, greater than or equal to about 1 nm, greater than or equal to about 1.1 nm, greater than or equal to about 1.3 nm, greater than or equal to about 1.5 nm, greater than or equal to about 1.7 nm, greater than or equal to about 1.9 nm, greater than or equal to about 2 nm, greater than or equal to about 2.1 nm, greater than or equal to about 2.3 nm, greater than or equal to about 2.5 nm, greater than or equal to about 2.7 nm, greater than or equal to about 2.9 nm, or greater than or equal to about 3 nm. A thickness of the first shell layer may be less than or equal to about 5 nm, less than or equal to about 4.5 nm, less than or equal to about 4 nm, less than or equal to about 3.5 nm, less than or equal to about 3 nm, or less than or equal to about 2.5 nm.

A thickness of the second shell layer (for example including a zinc sulfide) may be greater than or equal to about 0.3 nm, greater than or equal to about 0.5 nm, greater than or equal to about 0.7 nm, greater than or equal to about 0.9 nm, greater than or equal to about 1 nm, greater than or equal to about 1.1 nm, greater than or equal to about 1.3 nm, greater than or equal to about 1.5 nm, greater than or equal to about 1.7 nm, greater than or equal to about 1.9 nm, greater than or equal to about 2 nm, greater than or equal to about 2.1 nm, greater than or equal to about 2.3 nm, greater than or equal to about 2.5 nm, greater than or equal to about 2.7 nm, greater than or equal to about 2.9 nm, or greater than or equal to about 3 nm. A thickness of the second shell layer may be less than or equal to about 5 nm, less than or equal to about 4.5 nm, less than or equal to about 4 nm, less than or equal to about 3.5 nm, less than or equal to about 3 nm, less than or equal to about 2.5 nm, less than or equal to about 2 nm, less than or equal to about 1.5 nm, less than or equal to about 1 nm, less than or equal to about 0.7 nm, or less than or equal to about 0.5 nm.

The first semiconductor nanocrystal or the core may not include manganese, copper, or a combination thereof. The first semiconductor nanocrystal or the core may or may not include tellurium.

In the light emitting device or the light emitting layer or film, the light emitting nanostructures may emit green light. The wavelength of the green light may be disclosed herein. A quantum yield or efficiency of the light emitting nanostructures may be greater than or equal to about 70%, greater than or equal to about 71%, greater than or equal to about 72%, greater than or equal to about 73%, greater than or equal to about 74%, greater than or equal to about 75%, greater than or equal to about 76%, greater than or equal to about 77%, greater than or equal to about 78%, greater than or equal to about 79%, greater than or equal to about 80%, greater than or equal to about 81%, greater than or equal to about 82%, greater than or equal to about 83%, greater than or equal to about 84%, greater than or equal to about 85%, or greater than or equal to about 90%. The light emitting nanostructures or the light emitting layer (film) may exhibit a maximum luminescent peak having a full width at half maximum of less than or equal to about 45 nm, as measured at room temperature (e.g., about 20 °C to 25 °C). The full width at half maximum may be less than or equal to about 45 nm, less than or equal to about 44 nm, less than or equal to about 43 nm, less than or equal to about 42 nm, less than or equal to about 41 nm, less than or equal to about 40 nm, less than or equal to about 39 nm, less than or equal to about 38 nm, less than or equal to about 37 nm, less than or equal to about 36 nm, less than or equal to about 35 nm, less than or equal to about 34 nm, or less than or equal to about 33 nm.

The light emitting nanostructures (e.g., included in the light emitting film or the light emitting device) may be prepared by a method as described herein. The method includes: in the presence of a nanoparticle (e.g., including a core) that includes the first semiconductor nanocrystal and an organic ligand (e.g., in an organic solvent), reacting a zinc precursor, a selenium precursor, and a sulfur precursor at a temperature of greater than about 320 °C, for example, greater than or equal to about 330 °C, greater than or equal to about 335 °C, or greater than or equal to about 340 °C to form a second semiconductor nanocrystal, wherein the selenium precursor and optionally the sulfur precursor are added or injected in a split manner (e.g., not all at once), intermittently to a reaction medium at least two times, in a different aliquot each time, respectively, optionally together with a zinc precursor. The selenium precursor and the sulfur precursor may be added separately. The selenium precursor and the sulfur precursor may be added without being mixed together. A predetermined amount of the selenium precursor is added first and then addition of the sulfur precursor (for example in the split manner) to the reaction medium may be started.

The selenium precursor may be added at least twice, at least three times, or at least four times in a different aliquot each time. For the addition of the selenium precursor, a second aliquot added secondly may be greater than a first aliquot added firstly. In the addition of the selenium precursor, a third aliquot added thirdly may be greater than a second aliquot added secondly. The sulfur precursor may be added once or at least twice, at least three times, or at least four times in the same aliquot or in different aliquots each time. For the addition of the sulfur precursor, a second aliquot added secondly may be greater than a first aliquot added firstly. In the addition of the sulfur precursor, a third aliquot added thirdly may be greater than a second aliquot added secondly.

For each of the precursors, an aliquot added each time may be controlled taking into consideration the types of the precursors, a reaction temperature, and a desired composition of the light emitting nanostructures. Without wishing to be bound by any theory, it is believed that controlling the manner (e.g., in terms of the amount and the number of times) of adding the precursors for the formation of the second semiconductor nanocrystal as described herein may minimize the difference that can occur otherwise depending on the growth site of the nanostructure, and this can also suppress the shape distortion for example due to the lattice mismatch between the zinc selenide and the zinc sulfide. The nanostructures prepared by the method disclosed herein may show, e.g., exhibit, the cubicity or the squareness together with a relatively increased size and a uniform size distribution.

Details of the first semiconductor nanocrystal are the same as described herein. The first semiconductor nanocrystal may be prepared in an appropriate manner. The core may be commercially available or may be prepared by any proper method. The core may be synthesized in a hot injection manner wherein a solution including a metal precursor (e.g., an indium precursor) and optionally a ligand is heated at a high temperature (e.g., of greater than or equal to about 200 °C) and then a phosphorous precursor is injected into the heated hot solution.

The zinc precursor may include a Zn metal powder, an alkylated Zn compound, Zn alkoxide, Zn carboxylate, Zn nitrate, Zn perchlorate, Zn sulfate, Zn acetylacetonate, Zn halide (e.g., zinc chloride), Zn cyanide, Zn hydroxide, Zn oxide, Zn peroxide, Zn carbonate, or a combination thereof. Examples of the zinc precursor may include dimethyl zinc, diethyl zinc, zinc acetate, zinc acetylacetonate, zinc iodide, zinc bromide, zinc chloride, zinc fluoride, zinc carbonate, zinc cyanide, zinc nitrate, zinc oxide, zinc peroxide, zinc perchlorate, zinc sulfate, and the like.

The selenium precursor may include selenium-trioctyl phosphine (Se-TOP), selenium-tributylphosphine (Se-TBP), selenium-triphenylphosphine (Se-TPP), or a combination thereof, but is not limited thereto.

The sulfur precursor may include hexane thiol, octane thiol, decane thiol, dodecane thiol, hexadecane thiol, mercapto propyl silane, sulfur-trioctyl phosphine (STOP), sulfur-tributylphosphine (S-TBP), sulfur-triphenylphosphine (S-TPP), sulfur-trioctylamine (S-TOA), bis(trimethylsilyl)methyl sulfide, bis(trimethylsilyl)sulfide, ammonium sulfide, sodium sulfide, or a combination thereof. The sulfur precursor may be injected once or at least twice.

The organic solvent may be a C6 to C22 primary amine such as hexadecylamine; a C6 to C22 secondary amine such as dioctylamine; a C6 to C40 tertiary amine such as trioctylamine; a nitrogen-containing heterocyclic compound such as pyridine; a C6 to C40 aliphatic hydrocarbon (e.g., alkane, alkene, alkyne, etc.) such as hexadecane, octadecane, octadecene, or squalane; a C6 to C30 aromatic hydrocarbon such as phenyldodecane, phenyltetradecane, or phenyl hexadecane; a phosphine substituted with a C6 to C22 alkyl group such as trioctyl phosphine; a phosphine oxide substituted with a C6 to C22 alkyl group such as trioctyl phosphine oxide; a C12 to C22 aromatic ether such as phenyl ether, or benzyl ether, or a combination thereof.

The organic ligand may coordinate to a surface of the light emitting nanostructures thus prepared. The organic ligand may help the dispersibility of the nanostructures in an organic medium (e.g., an organic solution). The organic ligand may include RCOOH, $RNH_2$, $R_2NH$, $R_3N$, RSH, $RH_2PO$, $R_2HPO$, RsPO, $RH_2P$, $R_2HP$, $R_3P$, ROH, RCOOR', $RPO(OH)_2$, RHPOOH, $R_2POOH$ (wherein R and R' are independently a C1 to C40 (or C3 to C24) aliphatic hydrocarbon group (e.g., alkyl group, alkenyl group alkynyl group), or C6 to C40 (or C6 to C24) aromatic hydrocarbon group (e.g., C6 to C20 aryl group)), or a combination thereof. The organic ligand may be used alone or as a mixture of two or more.

Examples of the organic ligand may include methane thiol, ethane thiol, propane thiol, butane thiol, pentane thiol, hexane thiol, octane thiol, dodecane thiol, hexadecane thiol, octadecane thiol, benzyl thiol; methane amine, ethane amine, propane amine, butyl amine, pentyl amine, hexyl amine, octyl amine, dodecyl amine, hexadecyl amine, octadecyl amine, dimethyl amine, diethyl amine, dipropyl amine; methanoic acid, ethanoic acid, propanoic acid, butanoic acid, pentanoic acid, hexanoic acid, heptanoic acid, octanoic acid, dodecanoic acid, hexadecanoic acid, octadecanoic acid, oleic acid, benzoic acid; phosphine such as substituted or unsubstituted methyl phosphine (e.g., trimethyl phosphine, methyldiphenyl phosphine, etc.), substituted or unsubstituted ethyl phosphine (e.g., triethyl phosphine, ethyldiphenyl phosphine, etc.), substituted or unsubstituted propyl phosphine, substituted or unsubstituted butyl phosphine, substituted or unsubstituted pentyl phosphine, substituted or unsubstituted octyl phosphine (e.g., trioctyl phosphine (TOP)), and the like; phosphine oxide such as substituted or unsubstituted methyl phosphine oxide (e.g., trimethyl phosphine oxide, methyldiphenyl phosphine oxide, etc.), substituted or unsubstituted ethyl phosphine oxide (e.g., triethyl phosphine oxide, ethyldiphenyl phosphine oxide, etc.), substituted or unsubstituted propyl phosphine oxide, substituted or unsubstituted butyl phosphine oxide, substituted or unsubstituted octyl phosphine oxide (e.g., trioctyl phosphine oxide (TOPO), and the like; a diphenyl phosphine, a triphenyl phosphine compound, or an oxide compound thereof; phosphonic acid, a C5 to C20 alkylphosphinic acid such as hexylphosphinic acid, octylphosphinic acid, dodecanephosphinic acid, tetradecanephosphinic acid, hexadecanephosphinic acid, or octadecanephosphinic acid, or C5 to C20 alkyl phosphonic acid but is not limited thereto. The organic ligand may include a combination of RCOOH and an amine (e.g., $RNH_2$, $R_2NH$, $R_3N$, or a combination thereof).

Reaction conditions such as a reaction time, a reaction temperature, and the like may be selected appropriately taking into consideration a desired composition of the nanostructure.

Heating (or vacuum treating) a zinc precursor and an organic solvent and optionally an organic ligand at a predetermined temperature (e.g., at a temperature of greater than or equal to about 100 °C) under vacuum, and then changing an atmosphere of a reaction system into an inert gas and heating the same at a predetermined temperature (e.g., at a temperature of greater than or equal to about 100 °C) may be carried out. Then, the particles including the first semiconductor nanocrystal may be added thereto and the precursors for the second semiconductor nanocrystal (i.e., the selenium precursor, the sulfur precursor, and optionally the zinc precursor) may be added in the manner as disclosed herein to carry out the reaction for the formation of the second semiconductor nanocrystal.

The zinc precursor and the selenium precursor may be reacted to form a first shell layer and then the zinc precursor and the sulfur precursor may be reacted to form a second shell layer. The reaction temperature may be greater than about 320 °C, greater than or equal to about 325 °C, greater than or equal to about 330°C, greater than or equal to about 335°C, or greater than or equal to about 340 °C. The reaction temperature may be less than or equal to about 380 °C, less than or equal to about 370°C, less than or equal to about 360°C, or less than or equal to about 350 °C.

An amount of each precursor and a concentration thereof may be selected taking into consideration a desired composition of the core and the shell, a reactivity between the core and shell precursors, or the like.

After the reaction, a non-solvent may be added to reaction products and the light emitting nanostructures coordinated with, e.g., bound to, the ligand compound may be separated. The non-solvent may be a polar solvent that is miscible with the solvent used in the core formation reaction, shell formation reaction, or a combination thereof and is not capable of dispersing the produced nanocrystals therein. The non-solvent may be selected taking into consideration the solvent used in the reaction and may be for example acetone, ethanol, butanol, isopropanol, ethanediol, water, tetrahydrofuran (THF), dimethylsulfoxide (DMSO), diethyl ether, formaldehyde, acetaldehyde, a solvent having a similar solubility parameter to the foregoing nonsolvents, or a combination thereof. Separation of the nanocrystal particles may involve centrifugation, sedimentation, chromatography, or distillation. The separated nanocrystal particles may be added to a washing (or dispersing) solvent and washed (or dispersed), if desired. Types of the washing (dispersing) solvent are not particularly limited and a solvent having similar solubility parameter to that of the ligand may be used and examples thereof may include hexane, heptane, octane, chloroform, toluene, benzene, or the like.

The light emitting layer 13 may include a monolayer of quantum dots. The light emitting layer 13 may include a monolayer of quantum dots, e.g., one or more, two or more, three or more, or four or more and 20 or less, 10 or less, 9 or less, 8 or less, 7 or less, or 6 or less, monolayers of quantum dots. The light emitting layer 13 may have a thickness of greater than or equal to about 5 nm, for example, greater than or equal to 10 nm, greater than or equal to about 20 nm, or greater than or equal to about 30 nm and less than or equal to about 200 nm, for example, less than or equal to about 150 nm, less than or equal to about 100 nm, less than or equal to about 90 nm, less than or equal to about 80 nm, less than or equal to about 70 nm, less than or equal to about 60 nm, or less than or equal to about 50 nm. The light emitting layer 13 may have a thickness of, for example 10 nm to about 150 nm, for example about 20 nm to about 100 nm, or for example about 30 nm to about 50 nm.

In an embodiment, the light emitting device may include a charge auxiliary layer (e.g., an electron auxiliary layer, a hole auxiliary layer, or a combination thereof) between the first electrically conducting layer and the second electrically conducting layer. The first electrode may be an anode, and a hole auxiliary layer 12 may be disposed between the first electrode 11 and the light emitting layer 13. The hole auxiliary layer 12 may have a layer, e.g., one or more layers, and may include, for example, a hole injection layer, a hole transport layer, an electron blocking layer (not shown), or a combination thereof.

The HOMO energy level of the hole auxiliary layer 12 may be matched with the HOMO energy level of the light emitting layer 13, so that the mobility of holes transferred from the hole auxiliary layer 12 to the light emitting layer 13 may be enhanced. The hole auxiliary layer 12 may include a hole injection layer proximate to the first electrode 11 and a hole transport layer proximate to the light emitting layer 13.

The hole auxiliary layer may include an organic compound. The organic compound may have a HOMO energy level of greater than or equal to about 5.0 eV, greater than or equal to about 5.1 eV, greater than or equal to about 5.2 eV, greater than or equal to about 5.3 eV, or greater than or equal to about 5.4 eV. The organic compound may have a HOMO energy level of less than or equal to about 5.5 eV, less than or equal to about 5.4 eV, less than or equal to about 5.3 eV, less than or equal to about 5.2 eV, or less than or equal to about 5.1 eV.

A material of the hole auxiliary layer 12 (e.g., a hole transport layer or hole injection layer) is not particularly limited. The material of the hole auxiliary layer may include poly(9,9-dioctyl-fluorene-co-N-(4-butylphenyl)-diphenylamine) (TFB), polyarylamine, poly(N-vinylcarbazole) (PVK), poly(3,4-ethylenedioxythiophene (PEDOT), poly(3,4-ethylenedioxythiophene)polystyrene sulfonate (PEDOT:PSS), polyaniline, polypyrrole, N,N,N',N'-tetrakis(4-methoxyphenyl)-benzidine (TPD), 4,4'-bis[N-(1-naphthyl)-N-phenyl-amino]biphenyl ($\alpha$-NPD), 4,4',4"-Tris[phenyl(m-tolyl)amino]triphenylamine (m-MTDATA), 4,4',4"-tris(N-carbazolyl)-triphenylamine (TCTA), 1,1-bis[(di-4-tolylamino)phenyl]cyclohexane (TAPC), p-type metal oxide (e.g., NiO, WOs, MoOs, etc.), a carbon-based material such as graphene oxide, or a combination thereof, but is not limited thereto.

The electron blocking layer (EBL) may include, for example, poly(3,4-ethylenedioxythiophene):poly(styrene sulfonate) (PEDOT:PSS), poly(9,9-dioctyl-fluorene-co-N-(4-butylphenyl)-diphenylamine) (TFB), polyarylamine, poly(N-vinylcarbazole), polyaniline, polypyrrole, N,N,N',N'-tetrakis(4-methoxyphenyl)-benzidine (TPD), 4,4'-bis[N-(1-naphthyl)-N-phenyl-amino]biphenyl ($\alpha$-NPD), m-MTDATA, 4,4',4"-tris(N-carbazolyl)-triphenylamine (TCTA), or a combination thereof, but is not limited thereto.

In the hole auxiliary layer(s), a thickness of each layer may be selected appropriately. A thickness of each layer may be greater than or equal to about 5 nm, greater than or equal to about 10 nm, greater than or equal to about 15 nm, or greater than or equal to about 20 nm and less than or equal to about 50 nm, less than or equal to about 40 nm, less than or equal to about 35 nm, or less than or equal to about 30 nm, but is not limited thereto.

The second electrode may be a cathode, and the electron auxiliary layer 14 may be disposed between the light-emitting layer 13 and the second electrode 15. The electron auxiliary layer 14 may include, for example, an electron injecting layer, an electron transporting layer, a hole blocking layer, or a combination thereof. The electron auxiliary layer may be, for example, an electron injecting layer (EIL) that facilitates electron injection, an electron transporting layer (ETL) that facilitates electron transport, or a hole blocking layer (HBL) that blocks hole movement, or a combination thereof. For example, an electron injecting layer may be disposed between the electron transport layer and the cathode. For example, a hole blocking layer may be disposed between the light-emitting layer and the electron transporting (injecting) layer, but is not limited thereto. The thickness of each layer may be appropriately selected. For example, the thickness of each layer may be greater than or equal to about 1 nm and less than or equal to about 500 nm, but is not limited thereto. The electron injecting layer may be an organic layer formed by deposition. The electron transporting layer may include inorganic oxide nanoparticles or be an organic layer formed by deposition.

The electron transporting layer (ETL) may include, for example, 1,4,5,8-naphthalene-tetracarboxylic dianhydride (NTCDA), bathocuproine (BCP), tris[3- (3-pyridyl)-mesityl]borane (3TPYMB), LiF, Alqs, Gaqs, Inqs, $Znq_2$, $Zn(BTZ)_2$, $BeBq_2$, ET204 (8-(4-(4,6-di(naphthalen-2-yl)-1,3,5-triazin-2-yl)phenyl)quinolone), 8-hydroxyquinolinato lithium (Liq), n-type metal oxide (e.g., ZnO, $HfO_2$, etc.), or a combination thereof, but is not limited thereto.

The hole blocking layer (HBL) may include, for example, 1,4,5,8-naphthalenetetracarboxylic dianhydride (NTCDA), bathocuproine (BCP), tris[3-(3-pyridyl)-mesityl]borane (3TPYMB), LiF, Alqs, Gaqs, Inqs, Znq2, $Zn(BTZ)_2$, $BeBq_2$, or a combination thereof, but is not limited thereto.

The electronic auxiliary layer 14 may include a plurality of metal oxide nanoparticles. The nanoparticles may include a metal oxide including zinc. The metal oxide may include a zinc oxide, a zinc magnesium oxide, or a combination thereof. The metal oxide may include $Zn_{1-x}M_xO$ (wherein, M is Mg, Ca, Zr, W, Li, Ti, Y, Al, Co, or a combination thereof and $0 \leq x \leq 0.5$). M may be magnesium (Mg). x may be greater than or equal to about 0.01 and less than or equal to about 0.3, for example, less than or equal to about 0.25, less than or equal to about 0.2, or less than or equal to about 0.15.

An absolute value of LUMO of the aforementioned quantum dots included in the light-emitting layer may be smaller than the absolute value of LUMO of the metal oxide. The nanoparticles may have an average size of greater than or equal to about 1 nm, for example, greater than or equal to about 1.5 nm, greater than or equal to about 2 nm, greater than or equal to about 2.5 nm, or greater than or equal to about 3 nm and less than or equal to about 10 nm, less than or equal to about 9 nm, less than or equal to about 8 nm, less than or equal to about 7 nm, less than or equal to about 6 nm, or less than or equal to about 5 nm. The nanoparticles may not be rod-shaped or a nanowire.

Each thickness of the electron auxiliary layer 14 (e.g., an electron injecting layer, an electron transporting layer, or a hole blocking layer) may be greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, greater than or equal to about 12 nm, greater than or equal to about 13 nm, greater than or equal to about 14 nm, greater than or equal to about 15 nm, greater than or equal to about 16 nm, greater than or equal to about 17 nm, greater than or equal to about 18 nm, greater than or equal to about 19 nm, or greater than or equal to about 20 nm and less than or equal to about 120 nm, less than or equal to about 110 nm, less than or equal to about 100 nm, less than or equal to about 90 nm, less than or equal to about 80 nm, less than or equal to about 70 nm, less than or equal to about 60 nm, less than or equal to about 50 nm, less than or equal to about 40 nm, less than or equal to about 30 nm, or less than or equal to about 25 nm, but is not limited thereto.

A device may have a normal structure. Referring to FIG. 3, the device includes an anode 10 disposed on a transparent substrate 100, e.g., a metal oxide-based transparent electrode (e.g., ITO electrode) and a cathode 50 (e.g., facing the anode) may include a conductive metal (Mg, Al, etc.) (e.g., having a relatively low work function). A hole auxiliary layer 20 (e.g., a hole injecting layer of, for example, PEDOT:PSS, p-type metal oxide, or a combination thereof; a hole transport layer of TFB, PVK, or a combination thereof; or a combination thereof) may be disposed between the transparent electrode 10 and the light-emitting layer 30. The hole injecting layer may be proximate to the transparent electrode and the hole transport layer may be proximate to the light-emitting layer. An electron auxiliary layer 40 such as an electron injecting layer /transporting layer may be disposed between the quantum dot light-emitting layer 30 and the cathode 50.

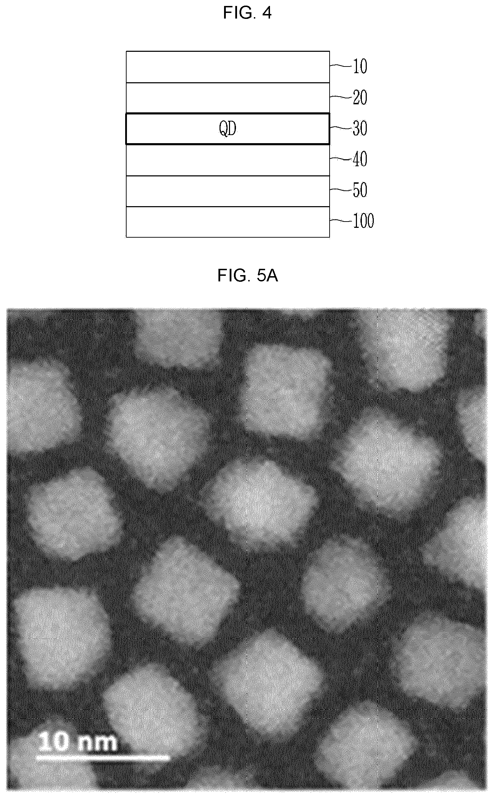

A device may have an inverted structure. For example, referring to FIG. 4, a cathode 50 is disposed on a transparent substrate 100, e.g., a metal oxide-based transparent electrode (e.g., ITO) and an anode 10 may include a metal (Au, Ag, etc.) (e.g., having a relatively high work function). For example, (optionally doped) n-type metal oxide (crystalline Zn metal oxide) may be disposed between the transparent electrode 50 and the light-emitting layer 30 as an electron auxiliary layer 40 (e.g., an electron transporting layer). A hole auxiliary layer 20 (e.g., a hole transport layer including TFB, PVK, or a combination thereof; a hole injecting layer including MoOs or other p-type metal oxides; or a combination thereof) may be disposed between the metal anode 10 and the quantum dot light-emitting layer 30.

The light emitting device of the invention may be prepared in an appropriate method. The light emitting device may be prepared by providing a first (or second) electrical conductor, optionally forming a charge auxiliary layer thereon for example by depositing or coating, and forming a light-emitting layer including the aforementioned light emitting nanostructures (e.g., a pattern thereof), optionally provide a charge auxiliary layer, and providing a second (or first) electrical conductor for example via deposition or coating.

The formation of the electrical conductor layer and the charge auxiliary layer (e.g., the hole auxiliary layer or the electron auxiliary layer) may be carried out appropriately and are not particularly limited.

It is appropriately selected considering a kind of the forming material, a thickness of the electrode/layer to be fabricated, and the like. The forming method may include a solution (wet) process, a deposition, or a combination thereof. For example, the hole auxiliary layer 12, the light-emitting layer 13, and the electron auxiliary layer 14 may be obtained by, for example, a solution process. The solution process may include, for example, a spin coating, a slit coating, an inkjet printing, a nozzle printing, a spraying, a doctor blade coating, or a combination thereof, but is not limited thereto.

When the electron auxiliary layer includes an inorganic material, the electron auxiliary layer may be formed by performing a wet process. The wet The wet process may include coating a dispersion in which nanoparticles are dispersed in a polar solvent on the light-emitting layer (e.g., by a spin coating, etc.); and drying and annealing the same. The polar solvent may include a C1 to C10 alcohol solvent such as ethanol, a C2 to C20 sulfoxide solvent such as dimethylsulfoxide, a C2 to C20 amide solvent such as dimethyl formamide, or a combination thereof, but is not limited thereto. The annealing may be performed at a predetermined temperature (e.g., a temperature of greater than or equal to about 60 °C, or greater than or equal to about 70 °C and less than or equal to about 100 °C, for example, less than or equal to about 90 °C, less than or equal to about 80 °C, or less than or equal to about 75 °C), for example, under vacuum, but is not limited thereto.

The forming of the light emitting layer 13 including the nanostructures may include obtaining a composition including the nanostructures and coating or depositing the composition on a substrate or a charge auxiliary layer by an appropriate method (e.g., by spin coating, inkjet printing, etc.). The applied or deposited light emitting layer may be heat-treated for drying. The heat-treating temperature is not particularly limited, and may be appropriately selected in consideration of a boiling point of the organic solvent used for preparing the dispersion. For example, the heat-treating temperature may be greater than or equal to about 60 °C, for example, greater than or equal to about 70 °C. The organic solvent for the dispersion including the nanostructures is not particularly limited and thus may be appropriately selected. The organic solvent may include a (substituted or unsubstituted) aliphatic hydrocarbon organic solvent, a (substituted or unsubstituted) aromatic hydrocarbon organic solvent, an acetate solvent, or a combination thereof.

The light emitting device may exhibit improved luminous properties (e.g., improved electroluminescent properties) or a combination thereof.

The light emitting device may exhibit a maximum external quantum efficiency (EQE) of greater than or equal to about 9%, greater than or equal to about 9.5%, greater than or equal to about 10%, greater than or equal to about 10.2%, greater than or equal to about 10.5%, greater than or equal to about 11%, greater than or equal to about 11.5%, greater than or equal to about 12%, greater than or equal to about 12.5%, greater than or equal to about 13%, greater than or equal to about 13.5%, or greater than or equal to about 14%. IThe light emitting device may exhibit a maximum luminance of greater than or equal to about 300,000 cd/m$^2$, greater than or equal to about 310,000 cd/m$^2$, greater than or equal to about 320,000 cd/m$^2$, greater than or equal to about 330,000 cd/m$^2$, greater than or equal to about 340,000 cd/m$^2$, or greater than or equal to about 350,000 cd/m$^2$.

The light emitting device may exhibit the aforementioned max EQE and the aforementioned max luminance.

Hereinafter, specific embodiments of the present invention are presented. However, the examples described below are only for specifically illustrating or explaining the invention, and thus the scope of the invention should not be limited.

Examples

Analysis Method

1. Photoluminescence Analysis and Absolute Quantum Yield (QY) measurement

(1) Photoluminescence (PL) spectra of the produced nanocrystals are measured at room temperature using a Hitachi F-7000 spectrophotometer and an irradiation wavelength of 458 nanometers (nm).
(2) An absolute quantum yield can be measured by using a Quantaurus-QY measurement equipment (Quantaurus-QY Absolute PL quantum yield spectrophotometer C11347-11) from Hamamatsu Co., Ltd, a multi-channel detector according to the instruction manual of the manufacturer.

2. Transmission Electron Microscopy (TEM) Analysis

Transmission electron microscopy photographs of nanocrystals quantum dots are obtained using an UT F30 Tecnai electron microscope.

3. High Resolution (HR) TEM, cubicity, squareness measurement

HR-TEM analysis is made using TEM-Titan G2 at a magnification from about 2,000,000 times to about 10,000,000 times (e.g., 5,000,000 times).

From the HR-TEM image, areas having a crystal lattice confirmed viewing in a direction of [100] are determined and the determined crystal areas are divided with the area of the light emitting nanostructures to obtain a cubicity.

From the HR-TEM Image, a smallest square for each particle is determined using an image handling program for example, provided by Microsoft Windows and an area of a given particle in the HR TEM image is divided with an area of the smallest square to provide a squareness of a given particle.

4. Inductively Coupled Plasma (ICP) Analysis

An inductively coupled plasma-atomic emission spectroscopy (ICP-AES) analysis is performed using Shimadzu ICPS-8100.

5. Electroluminescence measurement

Electroluminescent properties of the obtained quantum dot light-emitting device are evaluated using a Keithley 2200 source measuring device and a Minolta CS2000 spectroradiometer (a current-voltage-luminance measurement equipment). A current depending on a voltage applied to the devices, luminance, and electroluminescence (EL) are measured by using the current-voltage-luminance-measuring equipment, and the external quantum efficiency is calculated.

Reference Example:

Indium acetate, zinc acetate, and palmitic acid are dissolved in 1-octadecene in a 200 milliliter (mL) reaction flask and then heated at 120 °C under vacuum.

A mole ratio among the indium, the zinc, and the palmitic acid is 1:1:3.

After 1 hour, an atmosphere of the reaction flask is changed into nitrogen. After a temperature in the reaction flask is increased to 280 °C, a mixed solution of tris(trimethylsilyl)phosphine ((TMS)sP) and trioctyl phosphine is rapidly injected into the reaction flask, and the reaction is allowed to continue for a predetermined time to obtain a desired first absorption wavelength in an ultraviolet-visible (UV-Vis) absorption spectrum. Then, the reaction solution is rapidly cooled to room temperature. Acetone is added to facilitate formation of a precipitate, the precipitate is separated with a centrifuge, and the isolated precipitate is dispersed in toluene to prepare a toluene dispersion.

(TMS)sP is used in an amount of 0.75 moles per one mole of indium.

The first semiconductor nanocrystal thus obtained shows a first absorption wavelength of about 453 nm or 442 nm in an ultraviolet-visible (UV-Vis) absorption spectrum.

Preparation Example 1:

Selenium is dispersed in trioctyl phosphine to prepare a 2 molar (M) Se/TOP stock solution, and sulfur is dispersed in trioctyl phosphine to prepare a 1 M S/TOP stock solution.

Zinc acetate and oleic acid are dissolved in trioctylamine in a 2 Liter (L) reaction flask, and the solution is vacuum-treated at 120 °C for 10 minutes. The reaction flask is filled with nitrogen ($N_2$), the solution is heated to 340 °C, and the toluene dispersion of the first semiconductor nanocrystal (first absorption wavelength: 453 nm) prepared in Reference Example is added to the reaction flask, and the Se/TOP stock solution and optionally a zinc oleate are intermittently injected three times into the reaction flask and a reaction is carried out for 100 minutes to form a particle including a zinc selenide semiconductor nanocrystal on the first semiconductor nanocrystal.

Then, at the same reaction temperature, the S/TOP stock solution and optionally a zinc oleate are injected once (or twice in the same or different aliquots)into the reaction flask and a reaction is carried out for 50 minutes to form a zinc sulfide semiconductor nanocrystal on the particle.

A mole ratio of the zinc precursor, the selenium precursor, and the sulfur precursor is 60:20:17.

During the injection of the selenium precursor, a mole ratio among a first aliquot, a second aliquot, and the third aliquot is about 1:1.5:2..

An excess amount of ethanol is added to facilitate formation of the light emitting nanostructures, which are then separated with a centrifuge. After the centrifugation, the supernatant is discarded and the precipitate is dried and then dispersed in toluene to obtain a solution (hereinafter, a QD solution).

An ICP-AES of the obtained light emitting nanostructures is analyzed, and the result data is listed in Table 1. A TEM analysis and a photoluminescent analysis are carried out and the results are shown in Table 2.

An XRD analysis is carried out for the obtained light emitting nanostructures, and the results confirm that they include a zinc blende crystalline structure.

Preparation Example 2

Light emitting nanostructures are prepared in the same manner as set forth in Preparation Example 1, except for using the first semiconductor nanocrystals of the first absorption peak of about 442 nm and controlling the amounts of the precursors to obtain the nanostructures having the ICP composition shown in Table 1.

An ICP-AES of the obtained light emitting nanostructures is analyzed, and the result data is listed in Table 1. A TEM analysis and a photoluminescent analysis are carried out and the results are shown in Table 2.

An XRD analysis is carried out for the obtained light emitting nanostructures, and the results confirm that they include a zinc blende crystalline structure.

Preparation Example 3

Light emitting nanostructures are prepared in the same manner as set forth in Preparation Example 1, except for using the first semiconductor nanocrystals of the first absorption peak of about 442 nm and controlling the amounts of the precursors to obtain the nanostructures having the composition shown in Table 1.

An ICP-AES of the obtained light emitting nanostructures is analyzed, and the result data is listed in Table 1. A TEM analysis and a photoluminescent analysis are carried out and the results are shown in Table 2.

An XRD analysis is carried out for the obtained light emitting nanostructures, and the results confirm that they include a zinc blende crystalline structure.

Preparation Example 4

Light emitting nanostructures are prepared in the same manner as set forth in Preparation Example 1, except for using the first semiconductor nanocrystals of the first absorption peak of about 442 nm and controlling the amounts of the precursors to obtain the nanostructures having the composition shown in Table 1.

An ICP-AES of the obtained light emitting nanostructures is analyzed, and the result data is listed in Table 1. A TEM analysis and a photoluminescent analysis are carried out and the results are shown in Table 2.

An XRD analysis is carried out for the obtained light emitting nanostructures, and the results confirm that they include a zinc blende crystalline structure.

Preparation Example 5

Light emitting nanostructures are prepared in the same manner as set forth in Preparation Example 1, except for using the first semiconductor nanocrystals of the first absorption peak of about 442 nm and controlling the amounts of the precursors to obtain the nanostructures having the composition shown in Table 1.

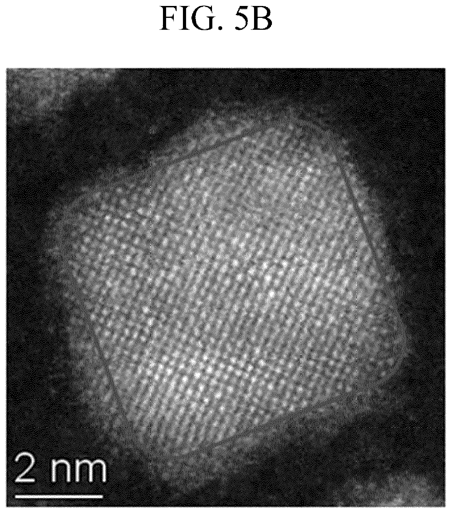

An ICP-AES of the obtained light emitting nanostructures is analyzed, and the result data is listed in Table 1. A TEM analysis, a HR-TEM analysis, and a photoluminescent analysis are carried out and the results are shown in Table 2 and FIG. 5A and FIG. 5B.

An XRD analysis is carried out for the obtained light emitting nanostructures, and the results confirm that they include a zinc blende crystalline structure.

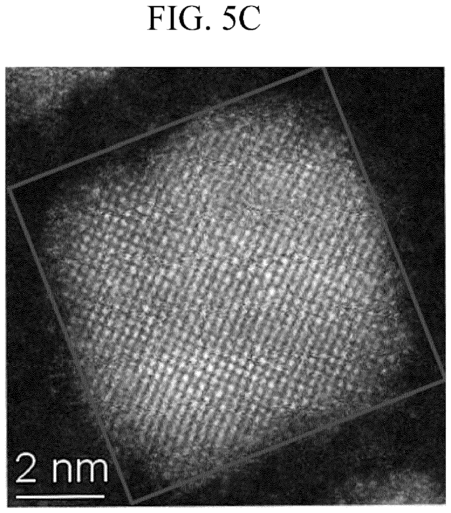

The results of FIG. 5A confirm that the light emitting nanostructures may exhibit relatively uniform cubic shape. The HR TEM results are shown in FIG. 5B and FIG. 5C. The results of FIG. 5B confirm that the light emitting nanostructures thus obtained exhibit (100) plane. In FIG. 5B, a region denoted with a square exhibits a noticeable lattice structure shown in a direction of [100] and in FIG. 5C, a region denoted with a square exhibit a smallest square of the nanocrystal particle. The cubicity is calculated by dividing an area of the noticeable lattice structure with an entire area of the two dimensional image of the given QD particle. An area of a given particle in the HR TEM image is divided with an area of the smallest square to provide a squareness of a given particle.

Preparation Comparative Example 1

Light emitting nanostructures are prepared in the same manner as set forth in Preparation Example 1, except that a reaction temperature is 320 °C and the same aliquot of the selenium precursor is injected for the intermittent injection.

An ICP-AES of the obtained light emitting nanostructures is analyzed, and the result data is listed in Table 1. A TEM analysis and a photoluminescent analysis are carried out and the results are shown in Table 2.

Preparation Comparative Example 2

Light emitting nanostructures are prepared in the same manner as set forth in Preparation Comparative Example 1, except for using the first semiconductor nanocrystals of the first absorption peak of about 442 nm and controlling the amounts of the precursors to obtain the nanostructures having the composition shown in Table 1.

An ICP-AES of the obtained light emitting nanostructures is analyzed, and the result data is listed in Table 1. A TEM analysis and a photoluminescent analysis are carried out and the results are shown in Table 2.

Table 1

|  | ICP mole ratio | | | | | |
|  | S: Se | Zn:In | Se:In | In:In | In:(S+Se) | Zn:(S+Se) |
|---|---|---|---|---|---|---|
| Prep. Example 1 | 0.464:1 | 49.9 | 29.2 | 1:1 | 0.02342:1 | 1.16862:1 |
| Prep. Example 2 | 0.314:1 | 57.6 | 39.3 | 1:1 | 0.01938:1 | 1.11628:1 |
| Prep. Example 3 | 0.308:1 | 58.1 | 39 | 1:1 | 0.01961:1 | 1.13922:1 |
| Prep. Example 4 | 0.357:1 | 60.2 | 38.9 | 1:1 | 0.01894:1 | 1.14015:1 |
| Prep. Example 5 | 0.246:1 | 62.9 | 48.3 | 1:1 | 0.01661:1 | 1.04485:1 |
| Prep. Comp. Example 1 | 0.587:1 | 40.5 | 21.8 | 1:1 | 0.02890:1 | 1.17052:1 |
| Prep. Comp. Example 2 | 0.257:1 | 104 | 74.6 | 1:1 | 0.01066:1 | 1.10874:1 |

Table 2

| | PL wavelength (nm) | FWHM (nm) | Absolute QY | Average (Avg.) particle size | particle size distribution (% of Avg. size) | cubicity | Average value of Squareness |
|---|---|---|---|---|---|---|---|
| Prep. Example 1 | 541 | 37 | 91 | 7.7 nm | 6% | 0.9 | 0.89 |
| Prep. Example 2 | 542 | 40 | 93 | 7.9 nm | 8% | 0.93 | 0.92 |
| Prep. Example 3 | 537 | 40 | 94 | 7.9 nm | 7% | 0.92 | 0.91 |
| Prep. Example 4 | 537 | 36 | 93 | 8.0 nm | 8% | 0.88 | 0.87 |
| Prep. Example 5 | 542 | 40 | 90 | 8.5 nm | 5% | 0.94 | 0.93 |
| Prep. Comp. Example 1 | 536 | 36 | 90 | 7.1 nm | 16% | 0.7 | 0.69 |
| Prep. Comp. Example 2 | 537 | 38 | 64 | 10.3 nm | 6% | 0.65 | 0.63 |
| FWHM = Full width at half maximum | | | | | | | |

The results confirm that the light emitting nanostructures of the examples may exhibit improved luminescent properties and a relatively high cubicity in comparison with the nanostructures of comparative Examples. The light emitting nanostructures of Comparative Example 1 show, e.g., exhibit, poor cubicity and the light emitting nanostructures of comparative example 2 show, e.g., exhibit, poor cubicity and poor luminescent properties.

Light Emitting Device

Example 1

The light-emitting device is fabricated using the light emitting nanostructures of preparation Example 1 according to the following method.

On an indium tin oxide (ITO) (anode)-deposited glass substrate, a poly(3,4-ethylenedioxythiophene)polystyrene sulfonate (PEDOT:PSS) solution (H.C. Starks) and poly[(9,9-dioctylfluorene-co-(4,4'-(N-4-butylphenyl)diphenylamine] solution (TFB) (Sumitomo) are spin-coated and then heat-treated as a hole injecting layer (HIL) and a hole transporting layer (HTL) with a thickness of 30 nm and a thickness of 25 nm, respectively. The nanostructures obtained from Preparation Example 1 are dispersed in octane and is spin-coated on the HTL and heat-treated to provide a light emitting film with a thickness of 25 nm,

On the light-emitting film is formed an electron transporting layer (ETL) including zinc oxide nanoparticles having a thickness of about 40 nm, and then an aluminum (Al) is vacuum-deposited on the ETL to provide a second electrically conducting layer. The electroluminescent properties of the obtained device are evaluated, and the results are shown in Table 3.

Example 2

A light-emitting device is fabricated in accordance with the same procedure as in Example 1, except for using the light emitting nanostructures of Preparation Example 2, instead of the nanostructures of Preparation Example 1 for the formation of the light emitting film. The electroluminescent properties of the obtained device are evaluated, and the results are shown in Table 3.

Example 3

A light-emitting device is fabricated in accordance with the same procedure as in Example 1, except for using the light emitting nanostructures of Preparation Example 3, instead of the nanostructures of Preparation Example 1 for the formation of the light emitting film. The electroluminescent properties of the obtained device are evaluated, and the results are shown in Table 3.

Example 4

A light-emitting device is fabricated in accordance with the same procedure as in Example 1, except for using the light emitting nanostructures of Preparation Example 4, instead of the nanostructures of Preparation Example 1 for the formation of the light emitting film. The electroluminescent properties of the obtained device are evaluated, and the results are shown in Table 3.

Example 5

A light-emitting device is fabricated in accordance with the same procedure as in Example 1, except for using the light emitting nanostructures of Preparation Example 5, instead of the nanostructures of Preparation Example 1 for the formation of the light emitting film. The electroluminescent properties of the obtained device are evaluated, and the results are shown in Table 3.

Comparative Example 1

A light-emitting device is fabricated in accordance with the same procedure as in Example 1, except for using the light emitting nanostructures of Preparation Comparative Example 1, instead of the nanostructures of Preparation Example 1 for the formation of the light emitting film. The electroluminescent properties of the obtained device are evaluated, and the results are shown in Table 3.

Comparative Example 2

A light-emitting device is fabricated in accordance with the same procedure as in Example 1, except for using the light emitting nanostructures of Preparation Comparative Example 2, instead of the nanostructures of Preparation Example 1 for the formation of the light emitting film. The electroluminescent properties of the obtained device are evaluated, and the results are shown in Table 3.

Table 3

|  | Maximum EQE (%) | Maximum Luminance (candelas per square meter (cd/m$^2$)) |
|---|---|---|
| Example 1 | 14.5 | 398389 |
| Example 2 | 12.3 | 382853 |
| Example 3 | 12.7 | 355401 |
| Example 4 | 10.3 | 407364 |
| Example 5 | 12.7 | 404200 |
| Comp. Example 1 | 7.0 | 141697 |
| Comp. Example 2 | 5.9 | 168041 |
| EQE = External quantum efficiency | | |

From the results of Table 3, it is confirmed that the devices according to Examples show, e.g., exhibit, significantly high luminous efficiency together with a significantly high luminance. The results also confirm that the light emitting devices of Examples may achieve a relatively high level of the combined electroluminescent properties in comparison with the device of Comparative Example.

While this disclosure has been described in connection with what is presently considered to be practical example embodiments, it is to be understood that the invention is not limited to the disclosed embodiments. On the contrary, it is intended to cover various modifications and equivalent arrangements included within the scope of the appended claims.

**Claims**

1.  A light-emitting device comprising

    a first electrically conducting layer,
    a second electrically conducting layer, and
    a light-emitting layer disposed between the first electrically conducting layer and the second electrically conducting layer, the light emitting layer comprising light emitting nanostructures,
    wherein the light emitting layer is configured to emit green light,
    wherein the light-emitting layer do not comprise cadmium, lead, or a combination thereof,
    wherein the light emitting nanostructures comprise a first semiconductor nanocrystal comprising a Group III-V compound and a second semiconductor nanocrystal comprising a zinc chalcogenide,
    wherein the Group III-V compound comprises indium, phosphorus, and optionally zinc,
    wherein the zinc chalcogenide comprises zinc, selenium, and sulfur,
    wherein the light emitting nanostructures exhibit a zinc blende structure, and
    wherein in a two dimensional image of the light emitting nanostructures obtained by an electron microscopy analysis, an average value of squareness of the light emitting nanostructures defined by the following equation is greater than or equal to 0.8:

    $$Squareness = A/C$$

    wherein A is an area of a given light emitting nanostructure in the two dimensional image, and C is an area of a smallest square that covers the given light emitting nanostructure.

2.  The light-emitting device of claim 1, wherein the green light has a maximum luminescent peak in a range of greater than or equal to 490 nanometers and less than or equal to 580 nanometers; and/or
    wherein each of the light emitting nanostructures has a core shell structure, and the core shell structure comprises a core comprising the first semiconductor nanocrystal and a shell comprising the second semiconductor nanocrystal.

3.  The light-emitting device of claims 1 or 2, wherein the light emitting nanostructures comprise a mole ratio of zinc to indium of greater than or equal to 43:1; and/or

    wherein the light emitting nanostructures comprise a mole ratio of sulfur to indium of greater than or equal to about 11.5:1; and/or
    wherein the light emitting nanostructures comprise a mole ratio of indium to a sum of selenium and sulfur of less than or equal to 0.04:1; and/or
    wherein the light emitting nanostructures comprise a mole ratio of zinc to a sum of selenium and sulfur of less than or equal to 1.5:1; and/or
    wherein the light emitting nanostructures comprise a mole ratio of sulfur to selenium of less than or equal to 0.5:1; and/or
    wherein the light emitting nanostructures comprise a mole ratio of selenium to indium of greater than or equal to 21.8:1.

4.  The light-emitting device of any of claims 1-3, wherein the average value of the squareness is greater than or equal to 0.85; and/or
    wherein an average size of the light emitting nanostructures is greater than or equal to 7 nanometers and a particle size distribution of the light emitting nanostructures is less than or equal to 10% of the average size of the light emitting nanostructures.

5.  The light-emitting device of any of claims 1-4, wherein the light emitting layer has a thickness of greater than or equal to 10 nanometers.

6.  The light-emitting device of any of claims 1-5, wherein the light emitting device further comprises an electron auxiliary layer, a hole auxiliary layer, or a combination thereof between the first electrically conducting layer and the second electrically conducting layer;
    preferably wherein the hole auxiliary layer comprises an organic compound, and the electron auxiliary layer comprises a zinc oxide nanoparticle optionally further comprising a first metal, and wherein the first metal comprises Mg, Ca, Zr, W, Li, Ti, Y, Al, Co, or a combination thereof.

7. A light emitting film comprising a plurality of light emitting nanostructures, wherein the light emitting film is configured to emit green light, wherein the plurality of light emitting nanostructures do not comprise cadmium, lead, or a combination thereof, wherein the light emitting nanostructures comprise a first semiconductor nanocrystal comprising a Group III-V compound and a second semiconductor nanocrystal comprising a zinc chalcogenide,

wherein the Group III-V compound comprises indium, phosphorus, and optionally zinc,
wherein the zinc chalcogenide comprises zinc, selenium, and sulfur,
wherein the light emitting nanostructures exhibit a zinc blende crystal structure,
wherein in a two dimensional image of the light emitting nanostructures obtained by an electron microscopy analysis, an average value of squareness of the light emitting nanostructures defined by the following equation is greater than or equal to about 0.8:

$$Squareness = A/C$$

wherein A is an area of a given light emitting nanostructure in the two dimensional image, and C is an area of a smallest square that covers the given light emitting nanostructure;
preferably wherein the light emitting nanostructures comprise a mole ratio of zinc to indium of greater than or equal to 43:1 and
wherein the light emitting nanostructures comprise a mole ratio of sulfur to indium of greater than or equal to 12.5:1.

8. The light-emitting film of claim 7, wherein the light emitting nanostructures comprise a mole ratio of indium to a sum of selenium and sulfur of less than or equal to 0.04:1, and
wherein the light emitting nanostructures comprise a mole ratio of zinc to a sum of selenium and sulfur of less than or equal to 1:5.

9. The light-emitting film of claims 7 or 8, wherein the average value of squareness of the light emitting nanostructures is greater than or equal to 0.83.

10. The light-emitting film of any of claims 7-9, wherein each of the light emitting nanostructures has a core shell structure, and the core shell structure comprises a core comprising the first semiconductor nanocrystal and the shell comprising the second semiconductor nanocrystal;

wherein the shell comprises
a first shell layer comprising zinc, selenium, and optionally sulfur, and
a second shell layer disposed on the first shell layer, the second shell layer comprising zinc, sulfur, and optionally selenium,
wherein a composition of the first shell layer is different than a composition of the second shell layer.

11. The light-emitting film of any of claims 7-10, wherein an average size of the light emitting nanostructures is greater than or equal to 7 nanometers and a particle size distribution of the light emitting nanostructures is less than or equal to 10% of the average size of the light emitting nanostructures.

12. The light-emitting film of any of claims 7-11, wherein the light emitting nanostructures are configured to emit green light, and
wherein the light emitting nanostructures is configured to exhibit a full width at half maximum of less than or equal to 37 nanometers.

**Patentansprüche**

1. Lichtemittierende Vorrichtung, umfassend

eine erste elektrisch leitende Schicht,
eine zweite elektrisch leitende Schicht und

eine lichtemittierende Schicht, die zwischen der ersten elektrisch leitenden Schicht und der zweiten elektrisch leitenden Schicht angeordnet ist, die lichtemittierende Schicht lichtemittierende Nanostrukturen umfassend, wobei die lichtemittierende Schicht konfiguriert ist, um grünes Licht zu emittieren, wobei die lichtemittierende Schicht kein Cadmium, Blei oder eine Kombination davon umfasst, wobei die lichtemittierenden Nanostrukturen einen ersten Halbleiter-Nanokristall, eine Verbindung der Gruppe III-V umfassend, und einen zweiten Halbleiter-Nanokristall umfassen, ein Zinkchalkogenid umfassend, wobei die Verbindung der Gruppe III-V Indium, Phosphor und gegebenenfalls Zink umfasst, wobei das Zinkchalkogenid Zink, Selen und Schwefel umfasst, wobei die lichtemittierenden Nanostrukturen eine Zinkblendestruktur zeigen, und wobei in einem zweidimensionalen Bild der lichtemittierenden Nanostrukturen, das durch eine elektronenmikroskopische Analyse erhalten wurde, ein Durchschnittswert der Rechtwinkligkeit der lichtemittierenden Nanostrukturen, definiert durch die folgende Gleichung, größer oder gleich 0,8 ist:

$$\text{Rechtwinkligkeit} = A/C$$

wobei A eine Fläche einer gegebenen lichtemittierenden Nanostruktur im zweidimensionalen Bild ist und C eine Fläche eines kleinsten Quadrats ist, das die gegebene lichtemittierende Nanostruktur abdeckt.

2. Lichtemittierende Vorrichtung nach Anspruch 1, wobei das grüne Licht einen maximalen Lumineszenzspitzenwert in einem Bereich von größer oder gleich 490 Nanometern und kleiner oder gleich 580 Nanometern aufweist; und/oder wobei jede der lichtemittierenden Nanostrukturen eine Kern-Hülle-Struktur aufweist und die Kern-Hülle-Struktur einen Kern, den ersten Halbleiter-Nanokristall umfassend, und eine Hülle umfasst, den zweiten Halbleiter-Nanokristall umfassend.

3. Lichtemittierende Vorrichtung nach Anspruch 1 oder 2, wobei die lichtemittierenden Nanostrukturen ein Molverhältnis von Zink zu Indium von größer oder gleich 43:1 umfassen; und/oder

wobei die lichtemittierenden Nanostrukturen ein Molverhältnis von Schwefel zu Indium von größer oder gleich ungefähr 11,5:1 umfassen; und/oder wobei die lichtemittierenden Nanostrukturen ein Molverhältnis von Indium zu einer Summe aus Selen und Schwefel von kleiner oder gleich 0,04:1 umfassen; und/oder wobei die lichtemittierenden Nanostrukturen ein Molverhältnis von Zink zu einer Summe aus Selen und Schwefel von kleiner oder gleich 1,5:1 umfassen; und/oder wobei die lichtemittierenden Nanostrukturen ein Molverhältnis von Schwefel zu Selen von kleiner oder gleich 0,5:1 umfassen; und/oder wobei die lichtemittierenden Nanostrukturen ein Molverhältnis von Selen zu Indium von größer oder gleich 21,8:1 umfassen.

4. Lichtemittierende Vorrichtung nach einem der Ansprüche 1-3, wobei der Durchschnittswert der Rechtwinkligkeit größer oder gleich 0,85 ist; und/oder wobei eine durchschnittliche Größe der lichtemittierenden Nanostrukturen größer oder gleich 7 Nanometer ist und eine Partikelgrößenverteilung der lichtemittierenden Nanostrukturen kleiner oder gleich 10 % der durchschnittlichen Größe der lichtemittierenden Nanostrukturen ist.

5. Lichtemittierende Vorrichtung nach einem der Ansprüche 1-4, wobei die lichtemittierende Schicht eine Dicke größer oder gleich 10 Nanometer aufweist.

6. Lichtemittierende Vorrichtung nach einem der Ansprüche 1-5, wobei die lichtemittierende Vorrichtung ferner eine Elektronenhilfsschicht, eine Lochhilfsschicht oder eine Kombination davon zwischen der ersten elektrisch leitenden Schicht und der zweiten elektrisch leitenden Schicht umfasst; wobei vorzugsweise die Lochhilfsschicht eine organische Verbindung umfasst und die Elektronenhilfsschicht ein Zinkoxid-Nanopartikel umfasst, gegebenenfalls ferner ein erstes Metall umfassend, und wobei das erste Metall Mg, Ca, Zr, W, Li, Ti, Y, Al, Co oder eine Kombination davon umfasst.

7. Lichtemittierender Film, eine Vielzahl von lichtemittierenden Nanostrukturen umfassend, wobei der lichtemittierende Film konfiguriert ist, um grünes Licht zu emittieren, wobei die Vielzahl von lichtemittierenden Nanostrukturen kein Cadmium, Blei oder eine Kombination davon umfassen, wobei die lichtemittierenden Nanostrukturen einen ersten Halbleiter-Nanokristall, eine Verbindung der Gruppe III-V umfassend, und einen zweiten Halbleiter-Nanokristall umfassen, ein Zinkchalkogenid umfassend,

> wobei die Verbindung der Gruppe III-V Indium, Phosphor und gegebenenfalls Zink umfasst,
> wobei das Zinkchalkogenid Zink, Selen und Schwefel umfasst,
> wobei die lichtemittierenden Nanostrukturen eine Zinkblendekristallstruktur zeigen, wobei in einem zweidimensionalen Bild der lichtemittierenden Nanostrukturen, das durch eine elektronenmikroskopische Analyse erhalten wurde, ein Durchschnittswert der Rechtwinkligkeit der lichtemittierenden Nanostrukturen, definiert durch die folgende Gleichung, größer oder gleich 0,8 ist:

$$\text{Rechtwinkligkeit} = A/C$$

> wobei A eine Fläche einer gegebenen lichtemittierenden Nanostruktur im zweidimensionalen Bild ist und C eine Fläche eines kleinsten Quadrats ist, das die gegebene lichtemittierende Nanostruktur abdeckt;
> wobei die lichtemittierenden Nanostrukturen vorzugsweise ein Molverhältnis von Zink zu Indium von größer oder gleich 43:1 umfassen und
> wobei die lichtemittierenden Nanostrukturen ein Molverhältnis von Schwefel zu Indium von größer oder gleich 12,5:1 umfassen.

8. Lichtemittierender Film nach Anspruch 7, wobei die lichtemittierenden Nanostrukturen ein Molverhältnis von Indium zu einer Summe aus Selen und Schwefel von kleiner oder gleich 0,04:1 umfassen, und wobei die lichtemittierenden Nanostrukturen ein Molverhältnis von Zink zu einer Summe aus Selen und Schwefel von kleiner oder gleich 1:5 umfassen.

9. Lichtemittierender Film nach Anspruch 7 oder 8, wobei der Durchschnittswert der Rechtwinkligkeit der lichtemittierenden Nanostrukturen größer oder gleich 0,83 ist.

10. Lichtemittierender Film nach einem der Ansprüche 7-9, wobei jede der lichtemittierenden Nanostrukturen eine Kern-Hülle-Struktur aufweist und die Kern-Hülle-Struktur einen Kern, den ersten Halbleiter-Nanokristall umfassend, und eine Hülle umfasst, den zweiten Halbleiter-Nanokristall umfassend;

> wobei die Hülle umfasst
> eine erste Hüllschicht, Zink, Selen und gegebenenfalls Schwefel umfassend, und
> eine zweite Hüllschicht, die auf der ersten Hüllschicht angeordnet ist, die zweite Hüllschicht Zink, Schwefel und gegebenenfalls Selen umfassend,
> wobei sich eine Zusammensetzung der ersten Hüllschicht von einer Zusammensetzung der zweiten Hüllschicht unterscheidet.

11. Lichtemittierender Film nach einem der Ansprüche 7-10, wobei eine durchschnittliche Größe der lichtemittierenden Nanostrukturen größer oder gleich 7 Nanometer ist und eine Partikelgrößenverteilung der lichtemittierenden Nanostrukturen kleiner oder gleich 10 % der durchschnittlichen Größe der lichtemittierenden Nanostrukturen ist.

12. Lichtemittierender Film nach einem der Ansprüche 7-11, wobei die lichtemittierenden Nanostrukturen konfiguriert sind, um grünes Licht zu emittieren, und wobei die lichtemittierenden Nanostrukturen konfiguriert sind, um eine Halbwertsbreite von kleiner oder gleich 37 Nanometern zeigen.

**Revendications**

1. Dispositif électroluminescent, comprenant

> une première couche électriquement conductrice,
> une seconde couche électriquement conductrice, et
> une couche électroluminescente disposée entre la première couche électroconductrice et la seconde couche électroconductrice, la couche électroluminescente comprenant des nanostructures électroluminescentes,
> dans lequel la couche électroluminescente est configurée pour émettre de la lumière verte,

dans lequel la couche électroluminescente ne comprend pas de cadmium, de plomb ou de combinaison de ceux-ci,

dans lequel les nanostructures électroluminescentes comprennent un premier nanocristal semi-conducteur comprenant un composé du groupe III-V et un second nanocristal semi-conducteur comprenant un chalcogénure de zinc,

dans lequel le composé du groupe III-V comprend de l'indium, du phosphore et éventuellement du zinc,

dans lequel le chalcogénure de zinc comprend du zinc, du sélénium et du soufre,

dans lequel les nanostructures électroluminescentes présentent une structure de mélange de zinc, et

dans lequel dans une image bidimensionnelle des nanostructures électroluminescentes obtenue par une analyse en microscopie électronique, une valeur moyenne d'équerrage des nanostructures électroluminescentes définie par l'équation suivante est supérieure ou égale à 0,8 :

$$\text{Équerrage} = A/C$$

dans lequel A est une zone d'une nanostructure électroluminescente donnée dans l'image bidimensionnelle, et C est une zone d'un plus petit carré qui couvre la nanostructure électroluminescente donnée.

2. Dispositif électroluminescent selon la revendication 1, dans lequel la lumière verte a un pic luminescent maximum dans une plage supérieure ou égale à 490 nanomètres et inférieure ou égale à 580 nanomètres ; et/ou

dans lequel chacune des nanostructures électroluminescentes a une structure coeur-coque, et la structure coeur-coque comprend un coeur comprenant le premier nanocristal semi-conducteur et une coque comprenant le second nanocristal semi-conducteur.

3. Dispositif électroluminescent selon la revendication 1 ou 2, dans lequel les nanostructures électroluminescentes comprennent un rapport molaire zinc/indium supérieur ou égal à 43:1 ; et/ou

dans lequel les nanostructures électroluminescentes comprennent un rapport molaire soufre/indium supérieur ou égal à environ 11,5:1 ; et/ou

dans lequel les nanostructures électroluminescentes comprennent un rapport molaire d'indium à une somme de sélénium et de soufre inférieur ou égal à 0,04:1 ; et/ou

dans lequel les nanostructures électroluminescentes comprennent un rapport molaire de zinc à une somme de sélénium et de soufre inférieur ou égal à 1,5:1 ; et/ou

dans lequel les nanostructures électroluminescentes comprennent un rapport molaire soufre/sélénium inférieur ou égal à 0,5:1 ; et/ou

dans lequel les nanostructures électroluminescentes comprennent un rapport molaire sélénium/indium supérieur ou égal à 21,8:1.

4. Dispositif électroluminescent selon l'une quelconque des revendications 1-3, dans lequel la valeur moyenne de l'équerrage est supérieure ou égale à 0,85 ; et/ou

dans lequel une taille moyenne des nanostructures électroluminescentes est supérieure ou égale à 7 nanomètres et une distribution granulométrique des nanostructures électroluminescentes est inférieure ou égale à 10 % de la taille moyenne des nanostructures électroluminescentes.

5. Dispositif électroluminescent selon l'une quelconque des revendications 1-4, dans lequel la couche électroluminescente a une épaisseur supérieure ou égale à 10 nanomètres.

6. Dispositif électroluminescent selon l'une quelconque des revendications 1-5, dans lequel le dispositif électroluminescent comprend en outre une couche auxiliaire d'électrons, une couche auxiliaire de trous, ou une combinaison de celles-ci entre la première couche électriquement conductrice et la seconde couche électriquement conductrice ; de préférence, dans lequel la couche auxiliaire de trous comprend un composé organique, et la couche auxiliaire d'électrons comprend une nanoparticule d'oxyde de zinc comprenant éventuellement en outre un premier métal, et dans lequel le premier métal comprend du Mg, Ca, Zr, W, Li, Ti, Y, Al, Co, ou une combinaison de ceux-ci.

7. Film électroluminescent comprenant une pluralité de nanostructures électroluminescentes, dans lequel le film électroluminescent est configuré pour émettre de la lumière verte, dans lequel la pluralité de nanostructures électroluminescentes ne comprennent pas de cadmium, de plomb ou de combinaison de ceux-ci, dans lequel les nanostructures électroluminescentes comprennent un premier nanocristal semi-conducteur comprenant un composé du groupe III-V et un second nanocristal semi-conducteur comprenant un chalcogénure de zinc,

> dans lequel le composé du groupe III-V comprend de l'indium, du phosphore et éventuellement du zinc,
> dans lequel le chalcogénure de zinc comprend du zinc, du sélénium et du soufre,
> dans lequel les nanostructures électroluminescentes présentent une structure cristalline de mélange de zinc,
> dans lequel dans une image bidimensionnelle des nanostructures électroluminescentes obtenue par une analyse par microscopie électronique, une valeur moyenne d'équerrage des nanostructures électroluminescentes définie par l'équation suivante est supérieure ou égale à environ 0,8 :

$$\text{Équerrage} = A/C$$

> dans lequel A est une zone d'une nanostructure électroluminescente donnée dans l'image bidimensionnelle, et C est une zone d'un plus petit carré qui couvre la nanostructure électroluminescente donnée ;
> de préférence, dans lequel les nanostructures électroluminescentes comprennent un rapport molaire zinc/indium supérieur ou égal à 43:1 et
> dans lequel les nanostructures électroluminescentes comprennent un rapport molaire soufre/indium supérieur ou égal à 12,5:1.

8. Film électroluminescent selon la revendication 7, dans lequel les nanostructures électroluminescentes comprennent un rapport molaire de l'indium à une somme de sélénium et de soufre inférieur ou égal à 0,04:1, et dans lequel les nanostructures électroluminescentes comprennent un rapport molaire de zinc à une somme de sélénium et de soufre inférieur ou égal à 1:5.

9. Film électroluminescent selon les revendications 7 ou 8, dans lequel la valeur moyenne d'équerrage des nanostructures électroluminescentes est supérieure ou égale à 0,83.

10. Film électroluminescent selon l'une quelconque des revendications 7-9, dans lequel chacune des nanostructures électroluminescentes a une structure coeur-coque, et la structure coeur-coque comprend un coeur comprenant le premier nanocristal semi-conducteur et la coque comprenant le second nanocristal semi-conducteur ;

> dans lequel la coque comprend
> une première couche de coque comprenant du zinc, du sélénium et éventuellement du soufre, et
> une seconde couche de coque disposée sur la première couche de coque, la seconde couche de coque comprenant du zinc, du soufre et éventuellement du sélénium,
> dans lequel une composition de la première couche de coque est différente d'une composition de la seconde couche de coque.

11. Film électroluminescent selon l'une quelconque des revendications 7-10, dans lequel une taille moyenne des nanostructures électroluminescentes est supérieure ou égale à 7 nanomètres et une distribution granulométrique des nanostructures électroluminescentes est inférieure ou égale à 10 % de la taille moyenne des nanostructures électroluminescentes.

12. Film électroluminescent selon l'une quelconque des revendications 7-11, dans lequel les nanostructures électroluminescentes sont configurées pour émettre de la lumière verte, et dans lequel les nanostructures électroluminescentes sont configurées pour présenter une largeur totale à mi-hauteur inférieure ou égale à 37 nanomètres.

FIG. 1

(100)

FIG. 2

10

15

14
13
12

11

FIG. 3

50

40

QD — 30

20

10

100

FIG. 4

FIG. 5A

10 nm

# FIG. 5B

# FIG. 5C

**EP 4 043 534 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2018151817 A1